# EUROPEAN PATENT APPLICATION

(11) **EP 4 358 150 A1**
(43) Date of publication of application: **24.04.2024**
(21) Application number: 23195061.9
(22) Date of filing: 04.09.2023
(51) Int. Cl.: H01L 29/06, H01L 29/08, H01L 29/40, H01L 29/417, H01L 29/66, H01L 29/775, B82Y 10/00

(54) **NANOSHEET DEVICE WITH SOURCE/DRAIN CONTACTS COMPRISING A SILICIDE MASK AND MANUFACTURING METHOD USING THE SILICIDE MASK**

(30) Priority: 20.10.2022 KR 20220135638; 17.02.2023 KR 20230021495
(71) Applicant: Samsung Electronics Co., Ltd., Suwon-si, Gyeonggi-do 16677 (KR)
(72) Inventor: PARK, Jun Ki, Suwon-si, 16677 (KR); KIM, Sung Hwan, Suwon-si, 16677 (KR); KIM, Wan Don, Suwon-si, 16677 (KR); RYU, Heung Seok, Suwon-si, 16677 (KR)
(74) Representative: Marks & Clerk LLP

(57) **Abstract**

A semiconductor device includes an active pattern (NS) extending in a first direction (D1), a plurality of gate structures (GS) on the active pattern spaced in the first direction, and including a gate electrode extending in a second direction (D2), a source/drain pattern (150) between adjacent gate structures, a silicide mask pattern (160) on the source/drain pattern, an upper surface of the silicide mask pattern being lower than an upper surface of the gate electrode, a source/drain contact (180) on the source/drain pattern connected to the source/drain pattern, and a contact silicide film (155) between the source/drain contact (180) and the source/drain pattern (150) in contact with a bottom surface of the silicide mask pattern, wherein a height from a lowermost part of the source/drain pattern to a lowermost part of the source/drain contact is smaller than a height from the lowermost part of the source/drain pattern to the bottom surface of the silicide mask pattern.

## Description

### BACKGROUND

### 1. Technical Field

The disclosure relates to a semiconductor device.

### 2. Description of the Related Art

As one of scaling technologies for increasing density of semiconductor device, a multi gate transistor in which a multi-channel active pattern (or a silicon body) having a fin or nanowire shape is formed on a substrate and a gate is formed on a surface of the multi-channel active pattern has been proposed.

Since such a multi gate transistor utilizes a three-dimensional channel, scaling is easily performed. Further, even if a gate length of the multi gate transistor is not increased, the current control capability may be improved. Furthermore, a SCE (short channel effect) in which potential of a channel region is influenced by a drain voltage may be effectively suppressed.

### SUMMARY

Aspects of the disclosure provide a semiconductor device capable of preventing an electrical short circuit between a contact silicide film and a gate electrode, thereby improving performance and reliability.

However, aspects of the disclosure are not restricted to the one set forth herein. The above and other aspects of the disclosure will become more apparent to one of ordinary skill in the art to which the present disclosure pertains by referencing the detailed description of the present disclosure given below.

In accordance with an aspect of the disclosure, a semiconductor device includes an active pattern extending in a first direction; a plurality of gate structures on the active pattern and spaced apart in the first direction, each of the plurality of gate structures including a gate electrode extending in a second direction, and a gate spacer on side walls of the gate electrode; a source/drain pattern between adjacent ones of the plurality of gate structures; a silicide mask pattern on the source/drain pattern, the silicide mask pattern including an upper surface and a bottom surface opposite to each other in a third direction, the upper surface of the silicide mask pattern being lower than an upper surface of the gate electrode; a source/drain contact on the source/drain pattern and connected to the source/drain pattern; and a contact silicide film between the source/drain contact and the source/drain pattern, the contact silicide film contacting the bottom surface of the silicide mask pattern, wherein a height from a lowermost part of the source/drain pattern to a lowermost part of the source/drain contact is smaller than a height from the lowermost part of the source/drain pattern to the bottom surface of the silicide mask pattern.

In accordance with an aspect of the disclosure, a semiconductor device includes an active pattern including a lower pattern extending in a first direction, and a plurality of sheet patterns spaced apart from the lower pattern in a third direction, the plurality of sheet patterns comprising an uppermost sheet pattern; a plurality of gate structures on the lower pattern spaced apart in the first direction, each of the plurality of gate structures including a gate electrode extending in a second direction; a source/drain pattern on the lower pattern and connected to the sheet patterns; a silicide mask pattern on the source/drain pattern, the silicide mask pattern including an upper surface and a bottom surface opposite to each other in the third direction, the upper surface of the silicide mask pattern being higher than an upper surface of the uppermost sheet pattern, and lower than an upper surface of the gate electrode; a source/drain contact on the source/drain pattern and connected to the source/drain pattern; and a contact silicide film between the source/drain contact and the source/drain pattern, the contact silicide film contacting the bottom surface of the silicide mask pattern.

In accordance with an aspect of the disclosure, a semiconductor device includes an active pattern including a lower pattern extending in a first direction, and a plurality of sheet patterns spaced apart from the lower pattern in a third direction, the plurality of sheet patterns including an uppermost sheet pattern; a plurality of gate structures on the lower pattern spaced apart in the first direction, each of the plurality of gate structures including a gate electrode extending in a second direction and a gate spacer on a side wall of the gate electrode; a source/drain pattern on the lower pattern and connected to the sheet patterns; a silicide mask pattern on the source/drain pattern, the silicide mask pattern including an upper surface and a bottom surface opposite to each other in the third direction; a source/drain contact on the source/drain pattern, the source/drain contact being in contact with the upper surface of the silicide mask pattern, a side wall of the source/drain contact being in contact with an outer side wall of the gate spacer; and a contact silicide film between the source/drain contact and the source/drain pattern, the contact silicide film being in contact with the bottom surface of the silicide mask pattern, wherein each of the plurality of gate structures includes a plurality of inner gate structures disposed between the lower pattern and the plurality of sheet patterns, and between adjacent ones of the plurality of sheet patterns, wherein each of the plurality of inner gate structures includes an uppermost inner gate structure in contact with a bottom surface of the uppermost sheet pattern, and wherein the bottom surface of the silicide mask pattern is lower than the upper surface of the uppermost inner gate structure, and is higher than the bottom surface of the uppermost inner gate structure.

At least some of the above and other features of the invention are set out in the claims.

### BRIEF DESCRIPTION OF DRAWINGS

The above and other aspects and features of the disclosure will become more apparent by describing in detail illustrative embodiments thereof with reference to the attached drawings, in which:
FIG. 1 is a layout diagram for explaining a semiconductor device according to an embodiment.
FIGS. 2 to 4 are cross-sectional views taken along A-A, B-B and C-C of FIG. 1.
FIG. 5 is an enlarged view of a portion P of FIG. 2.
FIG. 6 is a diagram for explaining a semiconductor device according to an embodiment.
FIG. 7 is a diagram for explaining a semiconductor device according to an embodiment.
FIG. 8 is a diagram for explaining a semiconductor device according to an embodiment.
FIGS. 9 and 10 are diagrams for explaining a semiconductor device according to an embodiment.
FIGS. 11 and 12 are diagrams for explaining a semiconductor device according to some embodiments.
FIG. 13 is a diagram for explaining a semiconductor device according to an embodiment.
FIG. 14 and 15 are diagrams for explaining the semiconductor device according to some embodiments.
FIG. 16 is a diagram for explaining the semiconductor device according to an embodiment.
FIG. 17 is a diagram for explaining a semiconductor device according to an embodiment.
FIG. 18 is a diagram for explaining a semiconductor device according to an embodiment.
FIG. 19 and 20 are diagrams for explaining a semiconductor device according to embodiments.
FIGS. 21 to 23 are diagrams for explaining a semiconductor device according to an embodiment.
FIGS. 24 to 31 are intermediate step diagrams for describing a method for fabricating a semiconductor device according to an embodiment.
FIGS. 32 to 38 are intermediate step diagrams for explaining a method for fabricating a semiconductor device according to an embodiment.

### DETAILED DESCRIPTION OF EMBODIMENTS

Although terms such as first and second are used to describe various elements or constituent elements in the disclosure, it goes without saying that these elements or constituent elements are not limited by these terms. These terms are only used to distinguish a single element or constituent element from other elements or constituent elements. Therefore, it goes without saying that a first element or constituent element referred to below may be a second element or constituent element within the technical idea of the disclosure.

Although drawings of a semiconductor device according to some embodiments show a fin-type Field Effect transistor (FinFET) including a channel region of a fin-type pattern shape, a transistor including a nanowire or a nanosheet, and a MBCFET^{™} (Multi-Bridge Channel Field Effect Transistor) as an example, the embodiment is not limited thereto.

The semiconductor device according to some embodiments may, of course, include a tunneling transistor (tunneling FET), a three-dimensional (3D) transistor or a vertical transistor (Vertical FET). The semiconductor device according to some embodiments may, of course, include a planar transistor. In addition, the technical idea of the disclosure may be applied to a transistor based on two-dimensional material (2D material based FETs) and a heterostructure thereof. Further, the semiconductor device according to some embodiments may also include a bipolar junction transistor, a laterally diffused metal oxide semiconductor (LDMOS), or the like.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present. Like numerals refer to like elements throughout.

Spatially relative terms, such as "over," "above," "on," "upper," "below," "under," "beneath," "lower," and the like, may be used herein for ease of description to describe one element's or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations) and the spatially relative descriptors used herein interpreted accordingly.

For the sake of brevity, conventional elements to semiconductor devices may or may not be described in detail herein for brevity purposes.

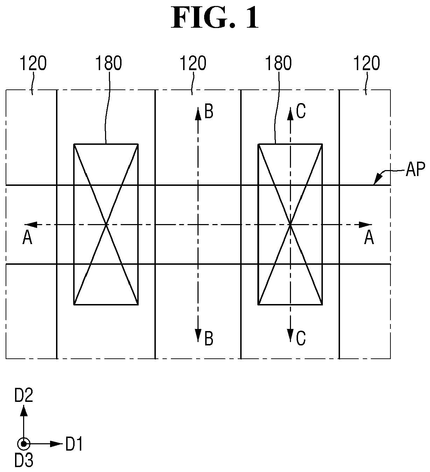

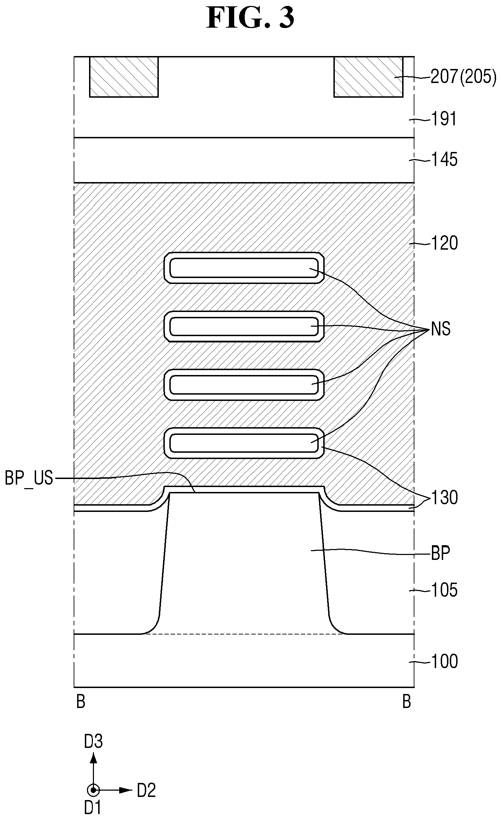

A semiconductor device according to some embodiments will be described with reference to FIGS. 1 to 5.

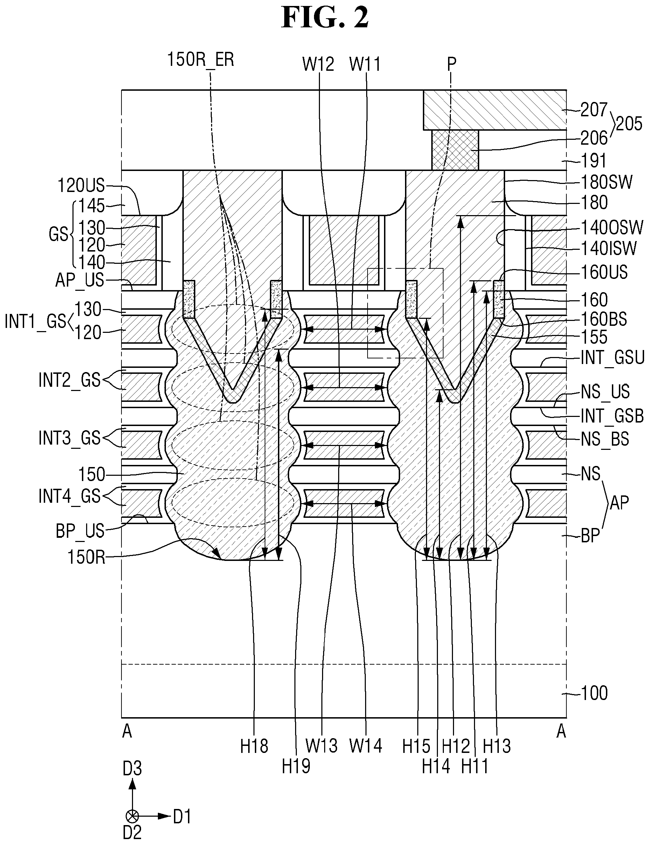

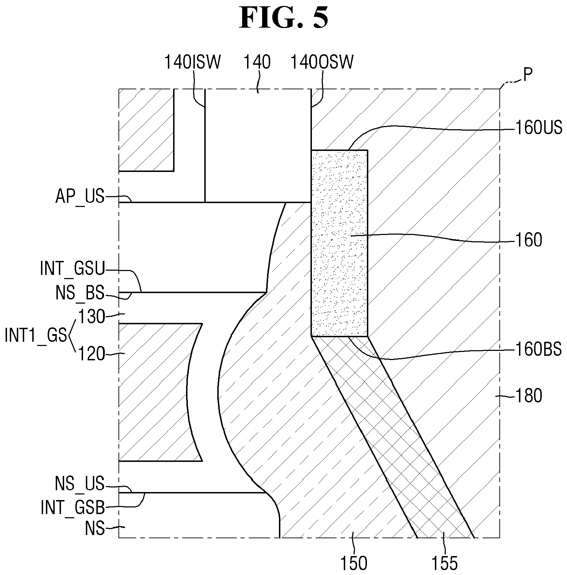

FIG. 1 is a layout diagram for explaining a semiconductor device according to some embodiments. FIGS. 2 to 4 are cross-sectional views taken along A-A, B-B and C-C of FIG. 1. FIG. 5 is an enlarged view of a portion P of FIG. 2. For convenience of explanation, FIG. 1 does not show a wiring structure 205.

Referring to FIGS. 1 to 5, the semiconductor device according to some embodiments may include an active pattern AP, a plurality of gate structures GS, a source/drain pattern 150, a contact silicide film 155, a silicide mask pattern 160, and a source/drain contact 180.

The substrate 100 may be made up of a semiconductor material or include a semiconductor material. The substrate 100 may be a silicon substrate or a silicon-on-insulator (SOI) substrate. In contrast, the substrate 100 may include, but is not limited to, silicon germanium, SGOI (silicon germanium on insulator), indium antimonide, lead tellurium compounds, indium arsenide, indium phosphide, gallium arsenide or gallium antimonide.

The active pattern AP may be disposed on the substrate 100. The active pattern AP may extend in a first direction D1. As an example, the active pattern AP may be disposed in a region in which an N-type Metal Oxide Semiconductor (NMOS) transistor is formed. As another example, the active pattern AP may be disposed in a region in which a P-type Metal Oxide Semiconductor (PMOS) is formed.

The active pattern AP may be, for example, a multi-channel active pattern. The active pattern AP may include a lower pattern BP and a plurality of sheet patterns NS. In the semiconductor device according to some embodiments, the active pattern AP may be an active pattern including nanosheet or nanowire.

The lower pattern BP may protrude from the substrate 100. The lower pattern BP may extend in the first direction D1.

A plurality of sheet patterns NS may be disposed on the lower pattern BP. The plurality of sheet patterns NS may be spaced apart from an upper surface BP_US of the lower pattern in a third direction D3. The sheet patterns NS may be spaced apart from each other in the third direction D3.

Each sheet pattern NS may include an upper surface NS_US and a bottom surface NS_BS. The upper surface NS_US of the sheet pattern is opposite to the bottom surface NS_BS of the sheet pattern in the third direction D3. Although four sheet patterns NS are shown as being disposed in the third direction D3, this is for convenience of explanation, and embodiments are not limited thereto.

The sheet pattern NS may include the uppermost sheet pattern that is farthest from the upper surface BP_US of the lower pattern. For example, the upper surface AP_US of the active pattern may be an upper surface of the uppermost sheet pattern among the sheet patterns NS.

Here, the third direction D3 may intersect the first direction D1 and a second direction D2. The first direction D1 may intersect the second direction D2. For example, the third direction D3 may be a thickness direction of the substrate 100.

The lower pattern BP may be formed by etching a part of the substrate 100, and may include an epitaxial layer grown from the substrate 100. The lower pattern BP may include silicon or germanium, which is an elemental semiconductor material. Further, the lower pattern BP may include a compound semiconductor, and may include, for example, a group IV-IV compound semiconductor or a group III-V compound semiconductor.

The group IV-IV compound semiconductor may include, for example, a binary compound or a ternary compound including at least two or more of carbon (C), silicon (Si), germanium (Ge), and tin (Sn), or a compound obtained by doping these elements with a group IV element.

The group III-V compound semiconductor may be, for example, one of a binary compound, a ternary compound or a quaternary compound formed by combining at least one of aluminum (Al), gallium (Ga) and indium (In) as a group III element with one of phosphorus (P), arsenic (As) and antimony (Sb) as a group V element.

The sheet pattern NS may include one of silicon or germanium which is an elemental semiconductor material, a group IV-IV compound semiconductor or a group III-V compound semiconductor. Each sheet pattern NS may include the same material as the lower pattern BP, and/or may include a different material from the lower pattern BP.

In the semiconductor device according to some embodiments, the lower pattern BP may be a silicon lower pattern including silicon, and the sheet pattern NS may be a silicon sheet pattern including silicon.

A width of the sheet pattern NS in the second direction D2 may increase or decrease in proportion to a width of the lower pattern BP in the second direction D2. As an example, although widths in the second direction D2 of the sheet patterns NS stacked in the third direction D3 are shown as being the same, this is only for convenience of explanation, and embodiments are not limited thereto. Unlike the shown example, the width in the second direction D2 of the sheet patterns NS stacked in the third direction D3 may decrease with distance from the lower pattern BP.

A field insulating film 105 may be formed on the substrate 100. The field insulating film 105 may be disposed on the side walls of the lower pattern BP. The field insulating film 105 is not disposed on the upper surface BP_US of the lower pattern.

As an example, the field insulating film 105 may completely cover the side walls of the lower pattern BP. Unlike the shown example, the field insulating film 105 may cover a part of the side walls of the lower pattern BP. In such a case, a part of the lower pattern BP may protrude beyond the upper surface of the field insulating film 105 in the third direction D3.

Each sheet pattern NS is disposed to be higher than the upper surface of the field insulating film 105. The field insulating film 105 may include, for example, an oxide film, a nitride film, an oxynitride film or a combination film thereof. Although the field insulating film 105 is shown as a single film, this is only for convenience of explanation, and embodiments are not limited thereto.

A plurality of gate structures GS may be disposed on the substrate 100. Each gate structure GS may extend in the second direction D2. The gate structures GS may be disposed to be spaced apart from each other in the first direction D1. The gate structures GS may be adjacent to each other in the first direction D1. For example, the gate structures GS may be disposed on both sides of the source/drain pattern 150 in the first direction D1. In other words, one gate structure GS may be disposed on one side of the source/drain pattern 150 and another gate structure GS may be disposed on the other side of the source/drain pattern 150.

The gate structure GS may be disposed on the active pattern AP. The gate structure GS may intersect the active pattern AP. The gate structure GS may intersect the lower pattern BP. The gate structure GS may wrap around all or a portion of each sheet pattern NS.

The gate structure GS may include, for example, a gate electrode 120, a gate insulating film 130, a gate spacer 140, and a gate capping pattern 145.

The gate structure GS may include a plurality of inner gate structures INT1_GS, INT2_GS, INT3_GS, and INT4_GS disposed between the sheet patterns NS adjacent to each other in the third direction D3, and between the lower pattern BP and the sheet pattern NS. The inner gate structures INT1_GS, INT2_GS, INT3_GS, and INT4_GS may be disposed between the upper surface BP_US of the lower pattern and the bottom surface NS_BS of the sheet pattern, and between the upper surface NS_US of the sheet pattern and the bottom surface NS_BS of the sheet pattern facing each other in the third direction D3.

The number of inner gate structures INT1_GS, INT2_GS, INT3_GS, and INT4_GS may be proportional to the number of sheet patterns NS included in the active pattern AP. For example, the number of inner gate structures INT1_GS, INT2_GS, INT3_GS, and INT4_GS may be the same as the number of sheet patterns NS. Since the active pattern AP includes a plurality of sheet patterns NS, the gate structure GS may include a plurality of inner gate structures.

The inner gate structures INT1_GS, INT2_GS, INT3_GS, and INT4_GS may be in contact with the upper surface BP_US of the lower pattern, the upper surface NS_US of the sheet pattern, and the bottom surface NS_BS of the sheet pattern. The inner gate structures INT1_GS, INT2_GS, INT3_GS, and INT4_GS may include an upper surface INT_GSU and a bottom surface INT_GSB that are opposite to each other in the third direction D3.

The bottom surface of the inner gate structure INT_GSB may face the upper surface of the lower pattern BP_US. The bottom surface INT_GSB of the inner gate structure may be in contact with the upper surface BP_US of the lower pattern or the upper surface NS_US of the sheet pattern. The upper surface INT_GSU of the inner gate structure may be in contact with the bottom surface of the sheet pattern NS_BS.

In the semiconductor device according to some embodiments, the inner gate structures INT1_GS, INT2_GS, INT3_GS, and INT4_GS may be in contact with a source/drain pattern 150 which will be described below. For example, the inner gate structures INT1_GS, INT2_GS, INT3_GS, and INT4_GS may be in direct contact with the source/drain pattern 150.

The following description will be provided using a case where the number of inner gate structures INT1_GS, INT2_GS, INT3_GS, and INT4_GS is four.

The gate structure GS may include a first inner gate structure INT1_GS, a second inner gate structure INT2_GS, a third inner gate structure INT3_GS, and a fourth inner gate structure INT4_GS. The first inner gate structure INT1_GS, the second inner gate structure INT2_GS, the third inner gate structure INT3_GS, and the fourth inner gate structure INT4_GS may be sequentially disposed on the lower pattern BP.

The fourth inner gate structure INT4_GS may be disposed between the lower pattern BP and the sheet pattern NS. The fourth inner gate structure INT4_GS may be in contact with the upper surface BP_US of the lower pattern. The fourth inner gate structure INT4_GS may be disposed at the lowermost position among the inner gate structures INT1_GS, INT2_GS, INT3_GS and INT4_GS. The fourth inner gate structure INT4_GS may be the lowermost inner gate structure.

The first inner gate structure INT1_GS, the second inner gate structure INT2_GS, and the third inner gate structure INT3_GS may be disposed between the sheet patterns NS adjacent to each other in the third direction D3. The second inner gate structure INT2_GS and the third inner gate structure INT3_GS may be disposed between the first inner gate structure INT1_GS and the fourth inner gate structure INT4_GS.

The first inner gate structure INT1_GS may be disposed at the uppermost position among the inner gate structures INT1_GS, INT2_GS, INT3_GS, and INT4_GS. The first inner gate structure INT1_GS may be in contact with the bottom surface NS_BS of the uppermost sheet pattern. The first inner gate structure INT1_GS may be the uppermost inner gate structure.

The inner gate structures INT1_GS, INT2_GS, INT3_GS, and INT4_GS include a gate electrode 120 and a gate insulating film 130 disposed between adjacent sheet patterns NS, and between the lower pattern BP and the sheet pattern NS.

The following description will be provided on the basis of FIG. 2, which is a cross-sectional view cut in the first direction D1.

For example, a width W11 of the first inner gate structure INT1_GS may be the same as a width W12 of the second inner gate structure INT2_GS and a width W13 of the third inner gate structure INT3_GS. A width W14 of the fourth inner gate structure INT4_GS may be the same as the width W13 of the third inner gate structure INT3_GS.

The second inner gate structure INT2_GS will be described as an example. The width W12 of the second inner gate structure INT2_GS may be measured in the middle (e.g., halfway) between the upper surface NS_US of the sheet pattern and the bottom surface NS_BS of the sheet pattern facing each other in the third direction D3.

A gate electrode 120 may be formed on the lower pattern BP. The gate electrode 120 may intersect the lower pattern BP. The gate electrode 120 may wrap the sheet pattern NS.

As shown, e.g., in FIG. 2, the upper surface 120US of the gate electrode is shown as being a concave curved surface, but is not limited thereto. The upper surface 120US of the gate electrode may be, e.g., a flat surface.

The gate electrode 120 may include at least one of metal, metal alloy, conductive metal nitride, metal silicide, doped semiconductor material, conductive metal oxide and conductive metal oxynitride. The gate electrode 120 may include, but is not limited to, for example, at least one of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonitride (TiAICN), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (NiPt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), and combinations thereof. The conductive metal oxide and conductive metal oxynitride may include, but are not limited to, an oxidized form of the aforementioned materials.

The gate electrode 120 may be disposed on both sides of a source/drain pattern 150, which will be described below. The gate structure GS may be disposed on both sides of the source/drain pattern 150 in the first direction D1.

As an example, both the gate electrodes 120 disposed on both sides of the source/drain pattern 150 may be normal gate electrodes used as gates of transistors. As another example, the gate electrode 120 disposed on one side of the source/drain pattern 150 may be used as a gate of a transistor, but the gate electrode 120 disposed on the other side of the source/drain pattern 150 may be a dummy gate electrode.

The gate insulating film 130 may extend along the upper surface of the field insulating film 105 and the upper surface BP_US of the lower pattern. The gate insulating film 130 may at least partially wrap around the plurality of sheet patterns NS. The gate insulating film 130 may be disposed along the periphery of the sheet pattern NS. The gate electrode 120 is disposed on the gate insulating film 130. The gate insulating film 130 is disposed between the gate electrode 120 and the sheet pattern NS.

In the semiconductor device according to some embodiments, the gate insulating film included in the inner gate structures INT1_GS, INT2_GS, INT3_GS, and INT4_GS may be in contact with the source/drain pattern 150 to be described below.

The gate insulating film 130 may include silicon oxide, silicon-germanium oxide, germanium oxide, silicon oxynitride, silicon nitride or a high dielectric constant material having a higher dielectric constant than silicon oxide. The high dielectric constant material may include, for example, one or more of boron nitride, hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide or lead zinc niobate.

Although the gate insulating film 130 is shown as a single film, this example is only for convenience of explanation and is not limited thereto. The gate insulating film 130 may include a plurality of films. The gate insulating film 130 may include an interfacial layer and a high dielectric constant insulating film disposed between the sheet pattern NS and the gate electrode 120. For example, the interfacial layer may not be formed along the profile of the upper surface of the field insulating film 105.

A semiconductor device according to some embodiments may include an NC (Negative Capacitance) FET that uses a negative capacitor. For example, the gate insulating film 130 may include a ferroelectric material film having ferroelectric properties, and a paraelectric material film having paraelectric properties.

The ferroelectric material film may have a negative capacitance, and the paraelectric material film may have a positive capacitance. For example, if two or more capacitors are connected in series and the capacitance of each capacitor has a positive value, the overall capacitances decrease from the capacitance of each of the individual capacitors. On the other hand, if at least one of the capacitances of two or more capacitors connected in series has a negative value, the overall capacitances may be greater than an absolute value of each of the individual capacitances, while having a positive value.

When the ferroelectric material film having the negative capacitance and the paraelectric material film having the positive capacitance are connected in series, the overall capacitance values of the ferroelectric material film and the paraelectric material film connected in series may increase. By the use of the increased overall capacitance value, a transistor including the ferroelectric material film may have a subthreshold swing (SS) below 60 mV/decade at room temperature.

The ferroelectric material film may have ferroelectric properties. The ferroelectric material film may include, for example, at least one of hafnium oxide, hafnium zirconium oxide, barium strontium titanium oxide, barium titanium oxide, and lead zirconium titanium oxide. Here, as an example, the hafnium zirconium oxide may be a material obtained by doping hafnium oxide with zirconium (Zr). As another example, the hafnium zirconium oxide may be a compound of hafnium (Hf), zirconium (Zr), and oxygen (O).

The ferroelectric material film may further include a dopant. For example, the dopant may include at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), and tin (Sn). The type of dopant included in the ferroelectric material film may vary, depending on which type of ferroelectric material is included in the ferroelectric material film.

When the ferroelectric material film includes hafnium oxide, the dopant included in the ferroelectric material film may include, for example, at least one of gadolinium (Gd), silicon (Si), zirconium (Zr), aluminum (Al), and yttrium (Y).

When the dopant is aluminum (Al), the ferroelectric material film may include 3 to 8 at% (atomic %) aluminum. Here, a ratio of the dopant may be a ratio of aluminum to the sum of hafnium and aluminum.

When the dopant is silicon (Si), the ferroelectric material film may include 2 to 10 at% silicon. When the dopant is yttrium (Y), the ferroelectric material film may include 2 to 10 at% yttrium. When the dopant is gadolinium (Gd), the ferroelectric material film may include 1 to 7 at% gadolinium. When the dopant is zirconium (Zr), the ferroelectric material film may include 50 to 80 at% zirconium.

The paraelectric material film may have paraelectric properties. The paraelectric material film may include at least one of, for example, a silicon oxide and a metal oxide having a high dielectric constant. The metal oxide included in the paraelectric material film may include, for example, but is not limited to, at least one of hafnium oxide, zirconium oxide, and aluminum oxide.

The ferroelectric material film and the paraelectric material film may include the same material. The ferroelectric material film has ferroelectric properties, but the paraelectric material film may not have ferroelectric properties. For example, when the ferroelectric material film and the paraelectric material film include hafnium oxide, a crystal structure of hafnium oxide included in the ferroelectric material film is different from a crystal structure of hafnium oxide included in the paraelectric material film.

The ferroelectric material film may have a thickness having the ferroelectric properties. A thickness of the ferroelectric material film may be, for example, but is not limited to, 0.5 to 10 nm. Since a critical thickness that exhibits the ferroelectric properties may vary for each ferroelectric material, the thickness of the ferroelectric material film may vary depending on the ferroelectric material.

As an example, the gate insulating film 130 may include one ferroelectric material film. As another example, the gate insulating film 130 may include a plurality of ferroelectric material films spaced apart from each other. The gate insulating film 130 may have a stacked film structure in which the plurality of ferroelectric material films and the plurality of paraelectric material films are alternately stacked.

The gate spacer 140 may be disposed on the side wall of the gate electrode 120. The gate spacers 140 may not be disposed between the lower pattern BP and the sheet pattern NS, and between the sheet patterns NS adjacent in the third direction D3.

The gate spacer 140 may include an inner side wall 140ISW and an outer side wall 140OSW opposite to each other in the first direction D1. The inner side wall 140ISW of the gate spacer may face the side wall of the gate electrode 120.

The gate spacer 140 may include, for example, at least one of silicon nitride (SiN), silicon oxynitride (SiON), silicon oxide (SiO₂), silicon oxycarbonitride (SiOCN), silicon boronitride (SiBN), silicon oxyboronitride (SiOBN), silicon oxycarbide (SiOC), and combinations thereof. Although the gate spacer 140 is shown to be a single film, this example is only for convenience of explanation and is not limited thereto.

A gate capping pattern 145 may be disposed on the gate electrode 120 and the gate spacer 140. The gate capping pattern 145 may cover the upper surface 120US of the gate electrode and the upper surface of the gate spacer 140.

Unlike the shown example, the gate capping pattern 145 may be disposed between the gate spacers 140. The gate capping pattern 145 may not cover the upper surface of the gate spacer 140.

The gate capping pattern 145 may include, for example, at least one of silicon nitride (SiN), silicon oxynitride (SiON), silicon carbonitride (SiCN), silicon oxycarbonitride (SiOCN), and combinations thereof. The gate capping pattern 145 may include a material having an etch selectivity with respect to the first interlayer insulating film 190.

A source/drain pattern 150 may be formed on the active pattern AP. The source/drain pattern 150 may be disposed on the lower pattern BP. The source/drain pattern 150 is connected to the sheet pattern NS. The source/drain pattern 150 comes into contact with the sheet pattern NS.

The source/drain pattern 150 may be disposed on the side surface of the gate structure GS. The source/drain patterns 150 may be disposed between the gate structures GS that are adjacent to each other in the first direction D1. For example, the source/drain patterns 150 may be disposed on both sides of each of the gate structures GS. Unlike the shown example, the source/drain pattern 150 may be disposed on one side of the gate structure GS and not disposed on the other side of the gate structure GS.

The source/drain pattern 150 may be included in a source/drain of a transistor that uses the sheet pattern NS as a channel region.

The source/drain pattern 150 may be disposed inside a source/drain recess 150R. The source/drain pattern 150 may fill the source/drain recess 150R.

The source/drain recess 150R may extend in the third direction D3. The source/drain recess 150R may be defined between the gate structures GS adjacent to each other in the first direction D1.

A bottom surface of the source/drain recess 150R is defined by the lower pattern BP. The side walls of the source/drain recess 150R may be defined by the sheet pattern NS and the inner gate structures INT1_GS, INT2_GS, INT3_GS, and INT4_GS. The inner gate structures INT1_GS, INT2_GS, INT3_GS, and INT4_GS include side walls that connect the upper surface INT_GSU of the inner gate structures to the bottom surface INT_GSB of the inner gate structure. The side walls of the inner gate structures INT1_GS, INT2_GS, INT3_GS, and INT4_GS may define a part of the side walls of the source/drain recess 150R.

Between the sheet pattern NS disposed at the lowermost part and the lower pattern BP, a boundary between the gate insulating film 130 and the lower pattern BP may be an upper surface BP_US of the lower pattern. The upper surface BP_US of the lower pattern may be a boundary between the fourth inner gate structure INT4_GS and the lower pattern BP.

A bottom surface of the source/drain recess 150R may be lower than the upper surface BP_US of the lower pattern. Since the source/drain pattern 150 fills the source/drain recess 150R, the lowermost part of the source/drain pattern 150 may be lower than the upper surface BP_US of the lower pattern.

Side walls of the source/drain recess 150R may have a wavy shape (see, e.g., FIG. 2). The source/drain recess 150R may include a plurality of width extension regions 150R_ER. Each width extension region 150R_ER may be defined above the upper surface BP_US of the lower pattern.

The width extension region 150R_ER may be defined between the sheet patterns NS adjacent to each other in the third direction D3. The width extension region 150R_ER may be defined between the lower pattern BP and the sheet pattern NS. Each width extension region 150R_ER may include a portion whose width in the first direction D1 increases with distance from the upper surface BP_US of the lower pattern and a portion whose width in the first direction D1 decreases with distance from the upper surface BP_US of the lower pattern. For example, the width of the width extension region 150R_ER may increase and then decrease, with distance from the upper surface BP_US of the lower pattern.

The source/drain pattern 150 may be in direct contact with the sheet pattern NS and the lower pattern BP. The gate insulating film 130 of the inner gate structures INT1_GS, INT2_GS, INT3_GS, and INT4_GS may be in direct contact with the source/drain pattern 150.

The source/drain patterns 150 may include an epitaxial pattern. The source/drain pattern 150 includes a semiconductor material. Although the source/drain pattern 150 is shown as being a single film, this is only for convenience of explanation, and embodiments are not limited thereto.

The source/drain pattern 150 may include, for example, silicon or germanium which is an elemental semiconductor material. Also, the source/drain pattern 150 may include a binary compound or a ternary compound including at least two or more of carbon (C), silicon (Si), germanium (Ge), and tin (Sn), or a compound obtained by doping these elements with a group IV element.

The source/drain pattern 150 may include impurities doped to the semiconductor material. For example, the source/drain pattern 150 may include n-type impurities. The doped n-type impurities may include at least one of phosphorous (P), arsenic (As), antimony (Sb) and bismuth (Bi). As another example, the source/drain pattern 150 may include p-type impurities. Doped p-type impurities may include at least one of boron (B) and gallium (Ga).

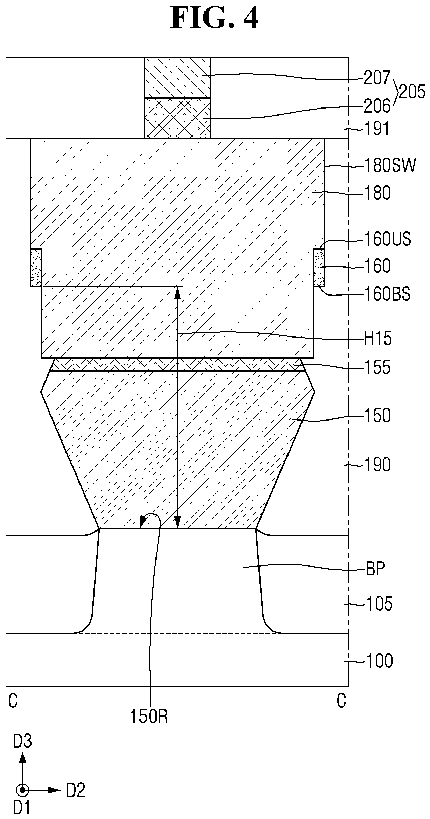

A first interlayer insulating film 190 (see, e.g., FIG. 4) may be disposed on the source/drain pattern 150. The first interlayer insulating film 190 may cover side walls of the source/drain pattern 150. The first interlayer insulating film 190 may not cover the upper surface of the gate capping pattern 145.

The first interlayer insulating film 190 may include, for example, at least one of silicon oxide, silicon nitride, silicon oxynitride, and a low dielectric constant material. The dielectric constant of the low dielectric constant material may have a value smaller than 3.9, which is a dielectric constant of silicon oxide.

A silicide mask pattern 160 may be disposed on the source/drain pattern 150. The silicide mask pattern 160 may be in contact with the outer side walls 140OSW of the gate spacer. In the semiconductor device according to some embodiments, at least a part of the silicide mask pattern 160 may extend along the outer side wall 140OSW of the gate spacer.

As shown, e.g., in FIG. 4, the silicide mask pattern 160 may be disposed in the first interlayer insulating film 190. The silicide mask pattern 160 may be disposed between the first interlayer insulating film 190 and a source/drain contact 180, which will be described below.

The silicide mask pattern 160 may include an upper surface 160US and a bottom surface 160BS opposite to each other in the third direction D3. The bottom surface 160BS of the silicide mask pattern may face the source/drain pattern 150. In terms of a cross-sectional view, the silicide mask pattern 160 may include side walls that connect the bottom surface 160BS of the silicide mask pattern to the upper surface 160US of the silicide mask pattern.

As shown, e.g., in FIG. 2, the silicide mask pattern 160 may include one side wall facing the gate spacer 140, and the other side wall facing the source/drain contact 180. A part of one side wall of the silicide mask pattern 160 may extend along the outer side wall 140OSW of the gate spacer. For example, a part of one side wall of the silicide mask pattern 160 may be in contact with the outer side wall 140OSW of the gate spacer. The source/drain pattern 150 may not be disposed between one side wall of the silicide mask pattern 160 and the outer side wall 140OSW of the gate spacer.

As shown, e.g., in FIG. 4, the silicide mask pattern 160 may include one side wall facing the first interlayer insulating film 190, and the other side wall facing the source/drain contact 180. One side wall of the silicide mask pattern 160 may be in contact with the first interlayer insulating film 190. The other side wall of the silicide mask pattern 160 may be in contact with the source/drain contact 180.

The silicide mask pattern 160 may include an insulating material. The silicide mask pattern 160 may include a material that has an etch selectivity with respect to the gate spacer 140 and the gate capping pattern 145. The silicide mask pattern 160 may include, for example, but is not limited to, at least one of silicon nitride (SiN), silicon oxynitride (SiON), silicon oxide (SiO₂), silicon oxycarbonitride (SiOCN), silicon boronitride (SiBN), silicon oxyboronitride (SiOBN), silicon oxycarbide (SiOC), silicon carbonitride (SiCN), and aluminum oxide (AIO).

The upper surface 160US of the silicide mask pattern may be lower than the upper surface 120US of the gate electrode. The upper surface 160US of the silicide mask pattern may be higher than the upper surface AP_US of the active pattern. For example, the upper surface 160US of the silicide mask pattern may be higher than the upper surface AP_US of the uppermost sheet pattern.

A height H11 from the lowermost part of the source/drain pattern 150 to the upper surface 160US of the silicide mask pattern may be smaller than a height H12 from the lowermost part of the source/drain pattern 150 to the upper surface 120US of the gate electrode. In other words, the height from the upper surface BP_US of the lower pattern to the upper surface 160US of the silicide mask pattern may be smaller than the height from the upper surface BP_US of the lower pattern to the upper surface 120US of the gate electrode. In the following description, a height of a certain position is compared on the basis of the lowermost part of the source/drain pattern 150. However, the height compared on the basis of the lowermost part of the source/drain pattern 150 may be directly applied to the height compared on the basis of the upper surface BP_US of the lower pattern.

The height H11 from the lowermost part of the source/drain pattern 150 to the upper surface 160US of the silicide mask pattern may be greater than the height H 13 from the lowermost part of the source/drain pattern 150 to the upper surface AP_US of the active pattern.

In the semiconductor device according to some embodiments, a height H15 from the lowermost part of the source/drain pattern 150 to the bottom surface 160BS of the silicide mask pattern may be smaller than the height H13 from the lowermost part of the source/drain pattern 150 to the upper surface AP_US of the active pattern.

For example, the bottom surface 160BS of the silicide mask pattern may be lower than the upper surface INT_GSU of the first inner gate structure INT1_GS. The bottom surface 160BS of the silicide mask pattern may be higher than the bottom surface INT_GSB of the first inner gate structure INT 1_GS.

In other words, the height H15 from the lowermost part of the source/drain pattern 150 to the bottom surface 160BS of the silicide mask pattern may be smaller than a height H18 from the lowermost part of the source/drain pattern 150 to the upper surface INT_GSU of the first inner gate structure INT1_GS. The height H15 from the lowermost part of the source/drain pattern 150 to the bottom surface 160BS of the silicide mask pattern may be greater than a height H19 from the lowermost part of the source/drain pattern 150 to the bottom surface INT_GSB of the first inner gate structure INT1_GS.

For example, the height H15 from the lowermost part of the source/drain pattern 150 to the bottom surface 160BS of the silicide mask pattern in FIG. 2 may be the same as the height H15 from the lowermost part of the source/drain pattern 150 to the bottom surface 160BS of the silicide mask pattern in FIG. 4.

A source/drain contact 180 may be disposed on the source/drain pattern 150. The source/drain contact 180 may be connected to the source/drain pattern 150. The source/drain contact 180 may be disposed inside the first interlayer insulating film 190. The first interlayer insulating film 190 does not cover the upper surface of the source/drain contacts 180. The upper surface of the source/drain contact 180 may be disposed on the same plane as the upper surface of the gate capping pattern 145, but is not limited thereto.

The source/drain contact 180 may cover the upper surface 160US of the silicide mask pattern. For example, the source/drain contact 180 may be in contact with the upper surface 160US of the silicide mask pattern.

As shown, e.g., in FIG. 2, the side wall 180SW of the source/drain contact may be in contact with the side walls of the gate structure GS. The first interlayer insulating film 190 may not be disposed between the gate structure GS and the source/drain contact 180. For example, the side walls 180SW of the source/drain contacts may be in contact with the outer side wall 140OSW of the gate spacer and the side walls of the gate capping pattern 145.

As shown, e.g., in FIG. 4, side walls 180SW of the source/drain contact may be in contact with the first interlayer insulating film 190. For example, the side walls 180SW of the source/drain contact located above the upper surface 160US of the silicide mask pattern may be flat surfaces.

The height H14 from the lowermost part of the source/drain pattern 150 to the lowermost part of the source/drain contact 180 may be smaller than the height H15 from the lowermost part of the source/drain pattern 150 to the bottom surface 160BS of the silicide mask pattern.

A part of the source/drain contact 180 may be disposed below the bottom surface 160BS of the silicide mask pattern. The remaining parts of the source/drain contacts 180 may be disposed above the bottom surface 160BS of the silicide mask pattern. As shown, e.g., in FIG. 2, the part of the source/drain contact 180 disposed below the bottom surface 160BS of the silicide mask pattern may have a triangular shape.

For example, the source/drain contact 180 may have a single film structure. The source/drain contact 180 may be formed of one conductive material. The source/drain contacts 180 may have a single conductive film structure. The source/drain contact 180 may include impurities that are introduced unintentionally in the process of forming the source/drain contact 180.

The source/drain contact 180 may include, for example, a metal. Although the source/drain contact 180 may include, for example, at least one of tungsten (W), molybdenum (Mo), ruthenium (Ru), and cobalt (Co), the disclosure is not limited thereto.

A contact silicide film 155 may be disposed between the source/drain contact 180 and the source/drain pattern 150. The contact silicide film 155 may be in contact with the source/drain contact 180 and the source/drain pattern 150.

As shown, e.g., in FIG. 2, the contact silicide film 155 may be in contact with the bottom surface 160BS of the silicide mask pattern. The contact silicide film 155 may wrap the source/drain contact 180 disposed below the bottom surface 160BS of the silicide mask pattern.

As shown, e.g., in FIG. 4, the contact silicide film 155 may not be in contact with the bottom surface 160BS of the silicide mask pattern. The bottom surface 160BS of the silicide mask pattern may be in contact with the first interlayer insulating film 190.

The contact silicide film 155 may include, for example, a metal silicide material. As an example, the contact silicide film 155 may include a metal silicide material that includes the metal included in the source/drain contact 180. As another example, the contact silicide film 155 may include a metal silicide material that includes a metal not included in the source/drain contact 180.

If the contact silicide film 155 approaches the gate electrode 120, the contact silicide film 155 may cause a short circuit between the source/drain pattern 150 and the gate electrode 120. Accordingly, the performance and reliability of the semiconductor device may be degraded.

Meanwhile, since the silicide mask pattern 160 is disposed on the source/drain pattern 150, a spaced distance between the contact silicide film 155 and the gate electrode 120 may further increase. Since the spaced distance between the contact silicide film 155 and the gate electrode 120 increases, the short circuit between the source/drain pattern 150 and the gate electrode 120 may be prevented. Therefore, the performance and reliability of the semiconductor device may be improved.

A second interlayer insulating film 191 may be disposed on the first interlayer insulating film 190. The second interlayer insulating film 191 may include, for example, at least one of silicon oxide, silicon nitride, silicon oxynitride, and a low dielectric constant material.

The wiring structure 205 may be disposed in the second interlayer insulating film 191. The wiring structure 205 may be connected to the source/drain contact 180. The wiring structure 205 may include a wiring line 207 and a wiring via 206.

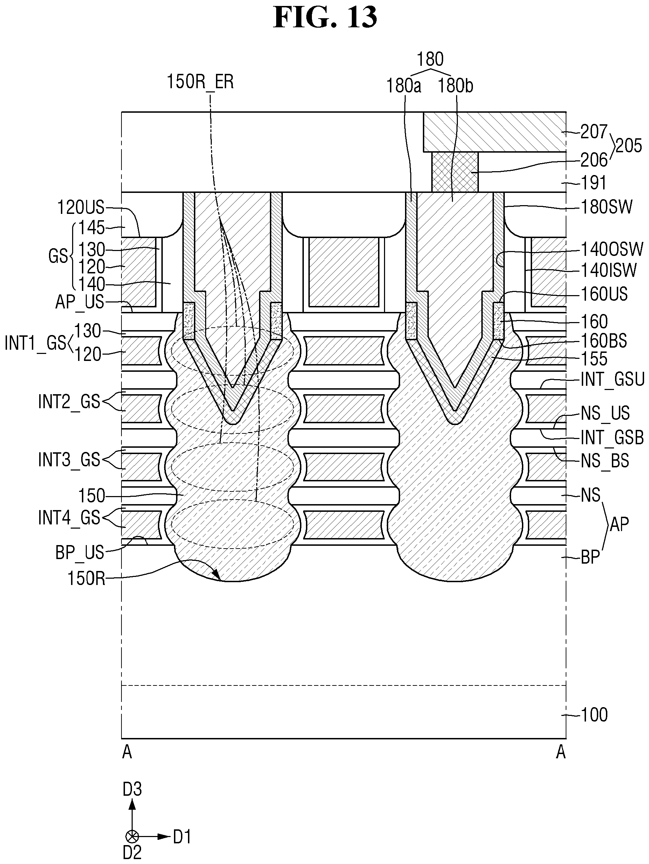

The wiring line 207 and the wiring via 206 may each include, for example, at least one of metal, conductive metal nitride, conductive metal carbide, conductive metal oxide, conductive metal carbonitride, and two-dimensional materials (2D material). Although the wiring line 207 and the wiring via 206 are each shown as a single conductive film structure, this is only for convenience of explanation, and the disclosure is not limited thereto. Unlike the shown example, at least one of the wiring lines 207 and the wiring via 206 may have a multiple conductive film structure including a barrier film and a plug film, as shown in the source/drain contact 180 of FIG. 13.

Although the wiring line 207 and the wiring via 206 are shown to be distinguished from each other, they are only for convenience of explanation, and the disclosure is not limited thereto. Unlike the shown example, the wiring structure 205 may have an integral structure in which there is no boundary distinguished between the wiring line 207 and the wiring via 206.

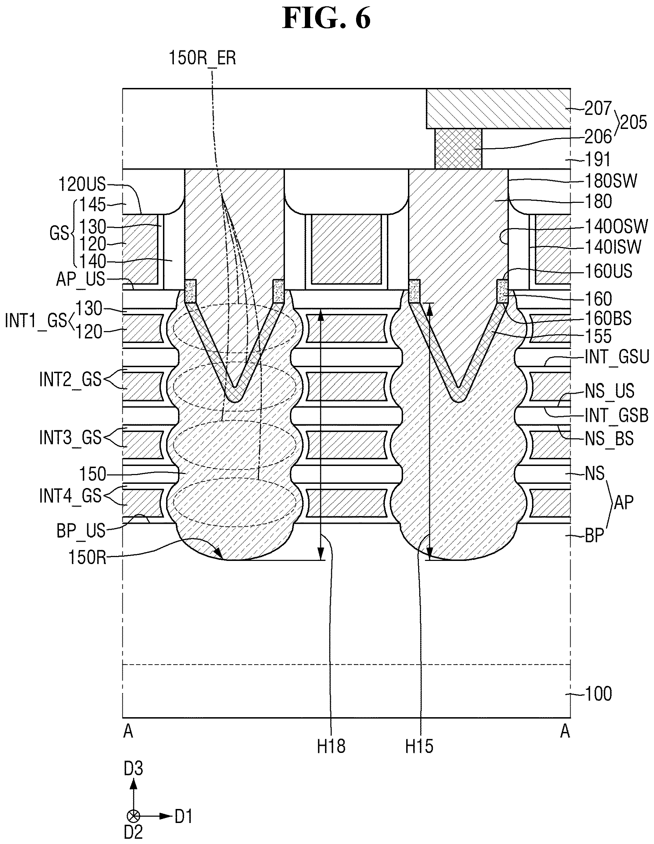

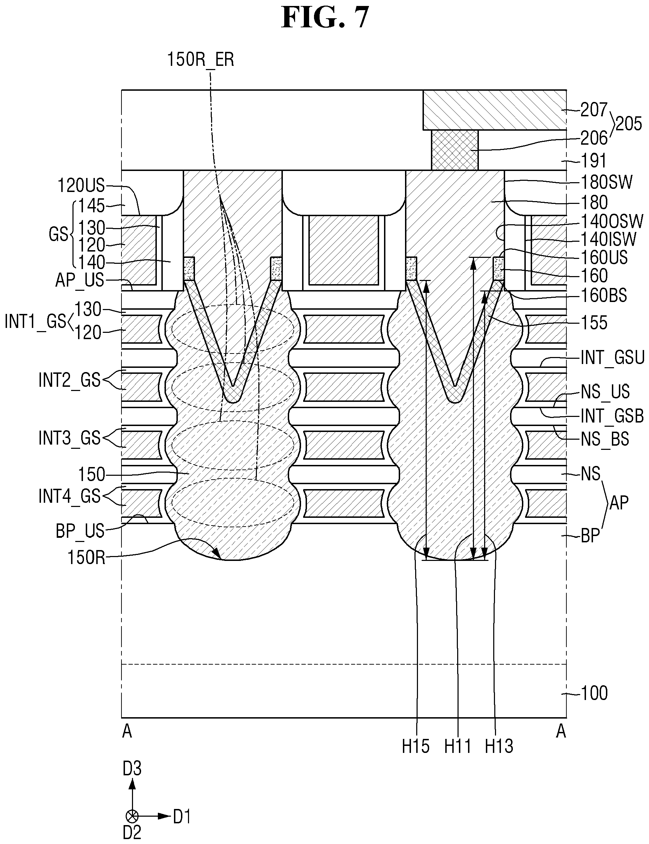

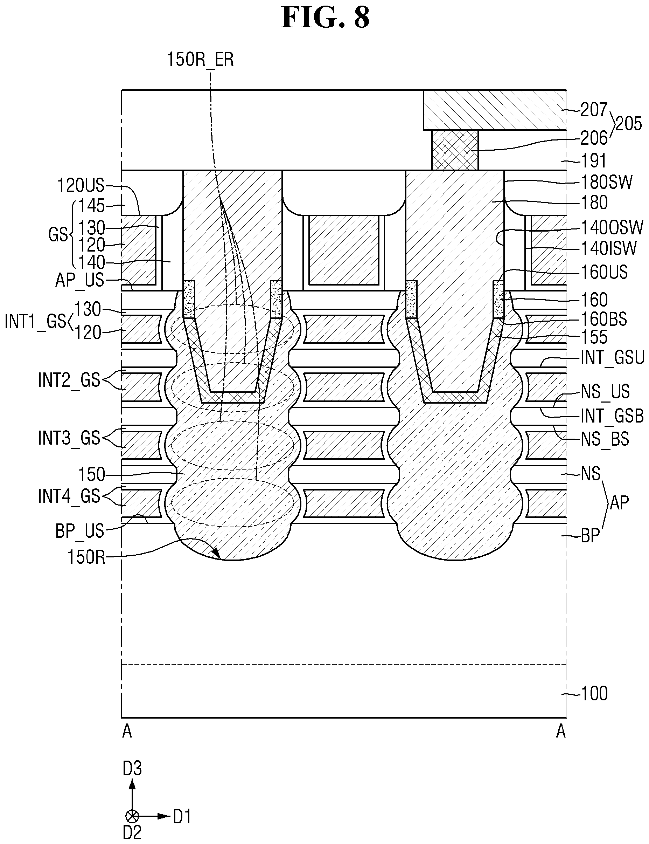

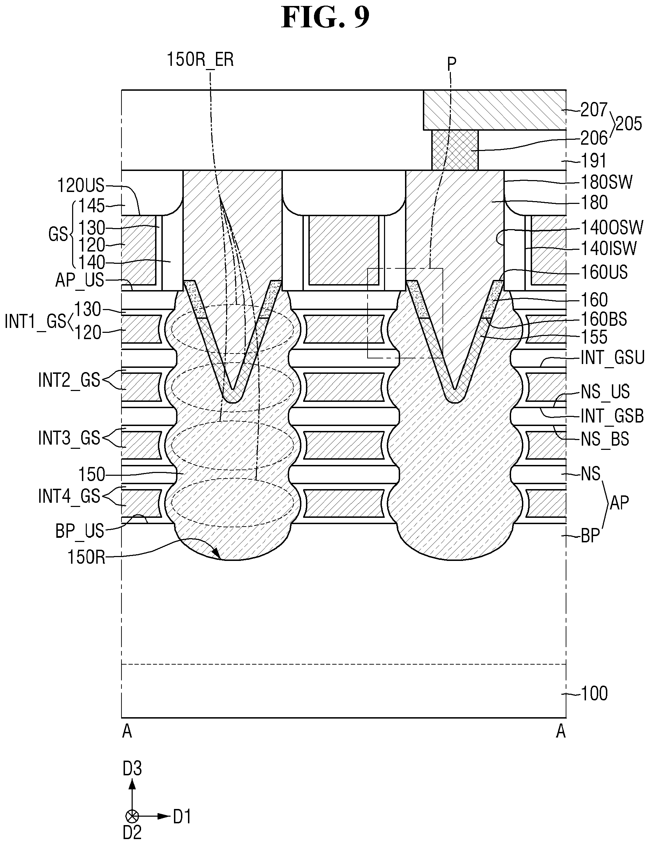

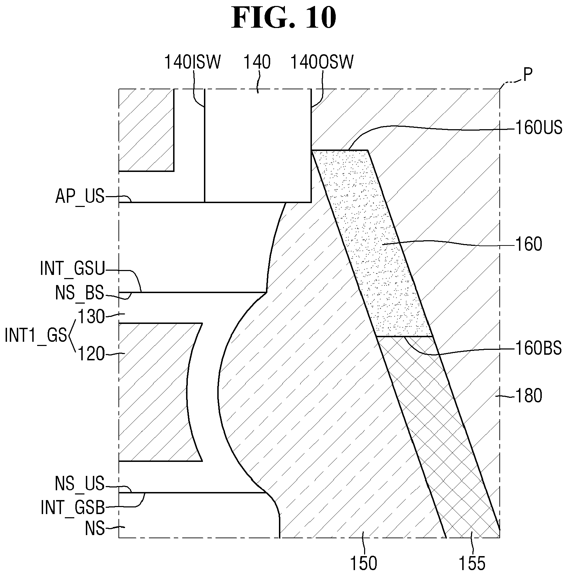

FIG. 6 is a diagram for explaining a semiconductor device according to some embodiments. FIG. 7 is a diagram for explaining a semiconductor device according to some embodiments. FIG. 8 is a diagram for explaining a semiconductor device according to some embodiments. FIGS. 9 and 10 are diagrams for explaining a semiconductor device according to some embodiments. For convenience of explanation, points that are different from those explained using FIGS. 1 to 5 will be mainly explained. For reference, FIG. 10 is an enlarged view of a portion P of FIG. 9.

Referring to FIG. 6, in the semiconductor device according to some embodiments, the bottom surface 160BS of the silicide mask pattern may be higher than the upper surface INT_GSU of the first inner gate structure INT1_GS.

The height H15 from the lowermost part of the source/drain pattern 150 to the bottom surface 160BS of the silicide mask pattern may be greater than a height H 18 from the lowermost part of the source/drain pattern 150 to the upper surface INT_GSU of the first inner gate structure INT1_GS.

Referring to FIG. 7, in the semiconductor device according to some embodiments, the bottom surface 160BS of the silicide mask pattern may be higher than the upper surface AP_US of the active pattern.

The height H15 from the lowermost part of the source/drain pattern 150 to the bottom surface 160BS of the silicide mask pattern may be greater than the height H 13 from the lowermost part of the source/drain pattern 150 to the upper surface AP_US of the active pattern.

One side wall of the silicide mask pattern 160 may extend along the outer side wall 140OSW of the gate spacer. For example, one side wall of the silicide mask pattern 160 may be entirely in contact with the outer side wall 140OSW of the gate spacer.

Referring to FIG. 8, in the semiconductor device according to some embodiments, the source/drain contact 180 disposed below the bottom surface 160BS of the silicide mask pattern may have a shape similar to an inverted trapezoid.

Referring to FIGS. 9 and 10, in the semiconductor device according to some embodiments, side walls of the silicide mask pattern 160 and the outer side wall 140OSW of the gate spacer may be disposed in a part of the source/drain pattern 150.

For example, the side walls of the silicide mask pattern 160 facing the gate spacer 140 may not be in contact with the outer side wall 140OSW of the gate spacer. For example, a corner of the silicide mask pattern 160 may contact the outer side wall 140OSW of the gate spacer.

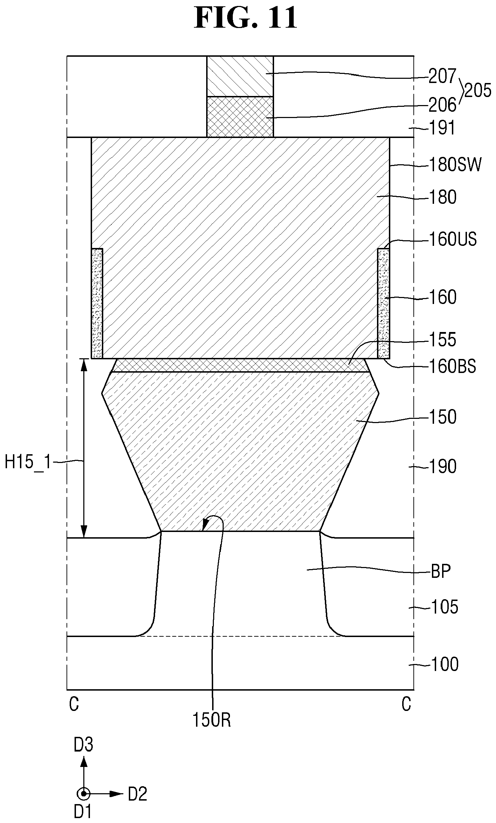

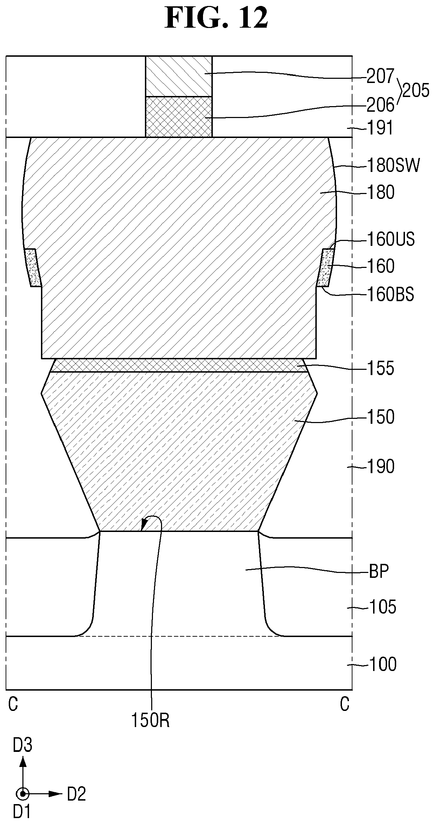

FIGS. 11 and 12 are diagrams for explaining the semiconductor device according to some embodiments, respectively. For convenience of explanation, points that are different from those explained using FIGS. 1 to 5 will be mainly explained.

Referring to FIGS. 2 and 11, in the semiconductor device according to some embodiments, the height of the bottom surface 160BS of the silicide mask pattern may vary depending on the cutting direction.

As shown, e.g., in FIG. 11, a height H15_1 from the lowermost part of the source/drain pattern 150 to the bottom surface 160BS of the silicide mask pattern may be smaller than the height H15 from the lowermost part of the source/drain pattern 150 to the bottom surface 160BS of the silicide mask pattern in FIG. 2.

Referring to FIG. 12, in the semiconductor device according to some embodiments, a part of the side wall 180SW of the source/drain contact 180 may be a convex curved surface.

For example, the side wall 180SW of the source/drain contact located above the upper surface 160US of the silicide mask pattern may be a convex curved surface. The side wall 180SW of the source/drain contact 180 located below the bottom surface 160BS of the silicide mask pattern may be a flat surface.

For example, side walls of the silicide mask pattern 160 that is in contact with the first interlayer insulating film 190 may be a convex curved surface.

FIG. 13 is a diagram for explaining a semiconductor device according to some embodiments. For convenience of explanation, points that are different from those explained using FIGS. 1 to 5 will be mainly explained.

Referring to FIG. 13, in the semiconductor device according to some embodiments, the source/drain contact 180 may include a contact barrier film 180a and a contact plug film 180b.

The contact barrier film 180a may extend along side walls of the contact plug film 180b. The contact barrier film 180a may be in contact with the outer side wall 140OSW of the gate spacer 140 and the side walls of the gate capping pattern 145.

The contact barrier film 180a may cover the upper surface 160US of the silicide mask pattern. For example, the contact barrier film 180a may be in contact with the upper surface 160US of the silicide mask pattern.

The contact barrier film 180a may include, for example, at least one of metal, conductive metal nitride, conductive metal carbide, conductive metal oxide, conductive metal carbonitride, and a two-dimensional material. The contact plug film 180b may include, for example, metal.

As an example, the contact silicide film 155 may include a metal silicide material including the metal included in the contact barrier film 180a. As another example, contact silicide film 155 may include a metal silicide material that includes a metal not included in the contact barrier film 180a.

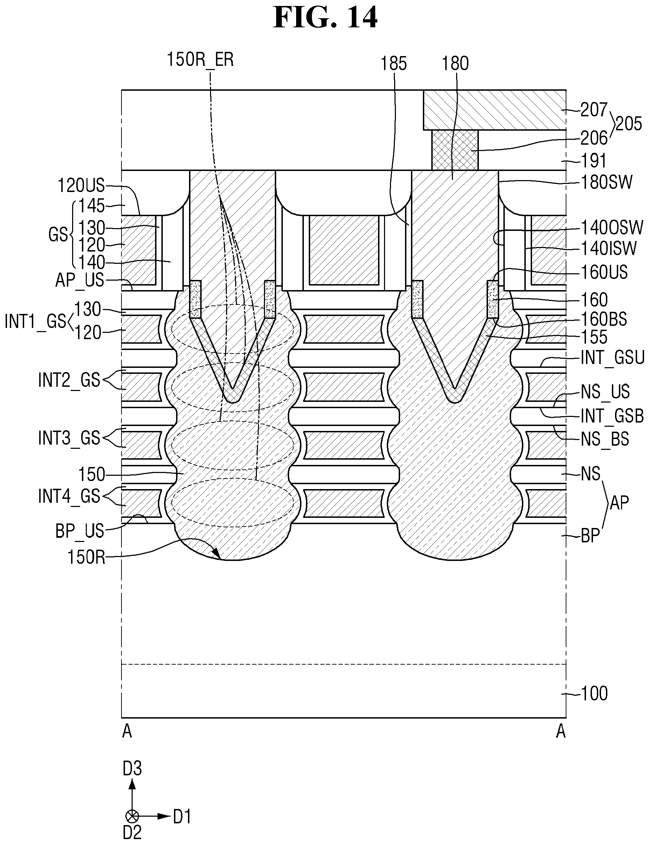

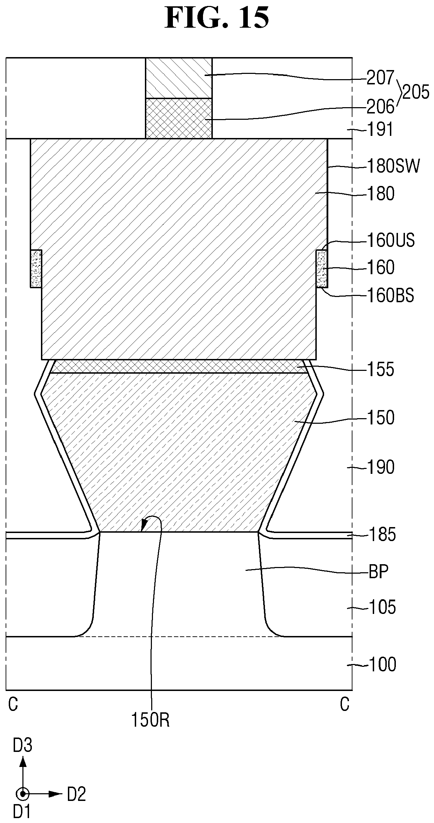

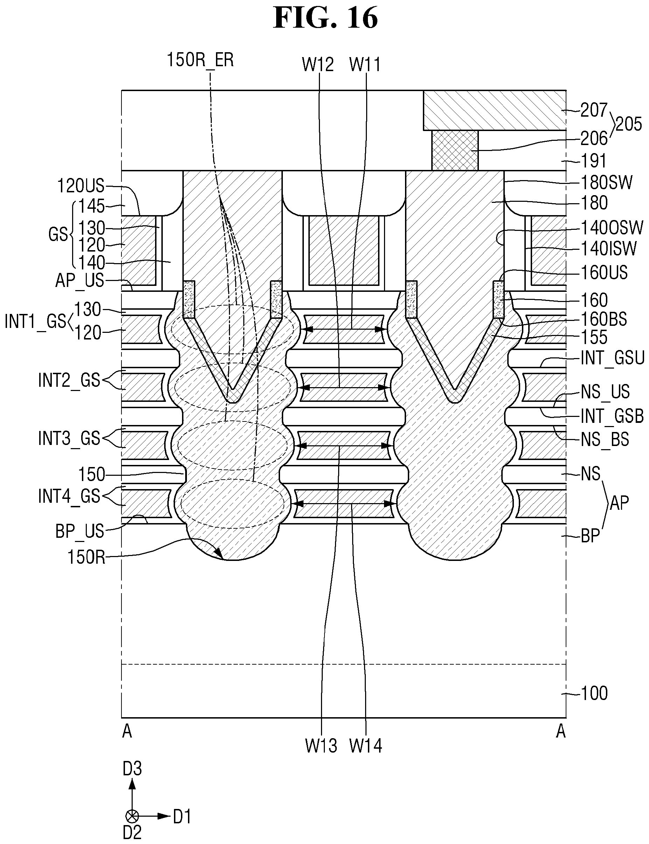

FIGS. 14 and 15 are diagrams for explaining a semiconductor device according to some embodiments. FIG. 16 is a diagram for explaining a semiconductor device according to some embodiments. For convenience of explanation, points that are different from those explained using FIGS. 1 to 5 will be mainly explained.

Referring to FIGS. 14 and 15, the semiconductor device according to some embodiments may further include a source/drain etch stop film 185 disposed between the gate structure GS and the source/drain contacts 180.

The source/drain etch stop film 185 may extend along the outer side wall 140OSW of the gate spacer, the side walls of the source/drain pattern 150 and the upper surface of the field insulating film 105. The source/drain etch stop film 185 may be in contact with the outer side wall 140OSW of the gate spacer and the side wall 180SW of the source/drain contact.

As shown, e.g., in FIG. 14, the side walls of the gate capping pattern 145 may be in contact with the side walls 180SW of the source/drain contact. The gate capping pattern 145 may cover the upper surface of the source/drain etch stop film 185. Alternatively, a part of the source/drain etch stop film 185 may be disposed between the side wall of the gate capping pattern 145 and the side wall 180SW of the source/drain contact.

If the upper surface of the source/drain pattern 150 protrudes above the upper surface AP_US of the active pattern, a part of the source/drain pattern 150 may be disposed between the outer side wall 140OSW of the gate spacer and the side wall of the silicide mask pattern 160.

As shown, e.g., in FIG. 15, the source/drain etch stop film 185 does not extend along the side walls 180SW of the source/drain contact. The side walls 180SW of the source/drain contacts 180 may be in contact with the first interlayer insulating film 190 and the silicide mask pattern 160.

The source/drain etch stop film 185 may include a material having an etch selectivity with respect to the first interlayer insulating film 190. The source/drain etch stop film 185 may include, for example, at least one of silicon nitride (SiN), silicon oxynitride (SiON), oxycarbonitride (SiOCN), silicon boronitride (SiBN), silicon oxyboronitride (SiOBN), silicon oxycarbide (SiOC), and combinations thereof.

Referring to FIG. 16, in the semiconductor device according to some embodiments, a width W14 of the fourth inner gate structure INT4_GS may be greater than a width W13 of the third inner gate structure INT3_GS.

For example, a width W12 of the second inner gate structure INT2_GS may be smaller than a width W13 of the third inner gate structure INT3_GS. The width W12 of the second inner gate structure INT2_GS may be greater than the width W11 of the first inner gate structure INT1_GS.

Alternatively, as an example, the width W12 of the second inner gate structure INT2_GS may be the same as the width W11 of the first inner gate structure INT1_GS and the width W13 of the third inner gate structure INT3_GS.

Alternatively, as another example, the width W12 of the second inner gate structure INT2_GS and the width W13 of the third inner gate structure INT3_GS may be smaller than the width W11 of the first inner gate structure INT1_GS.

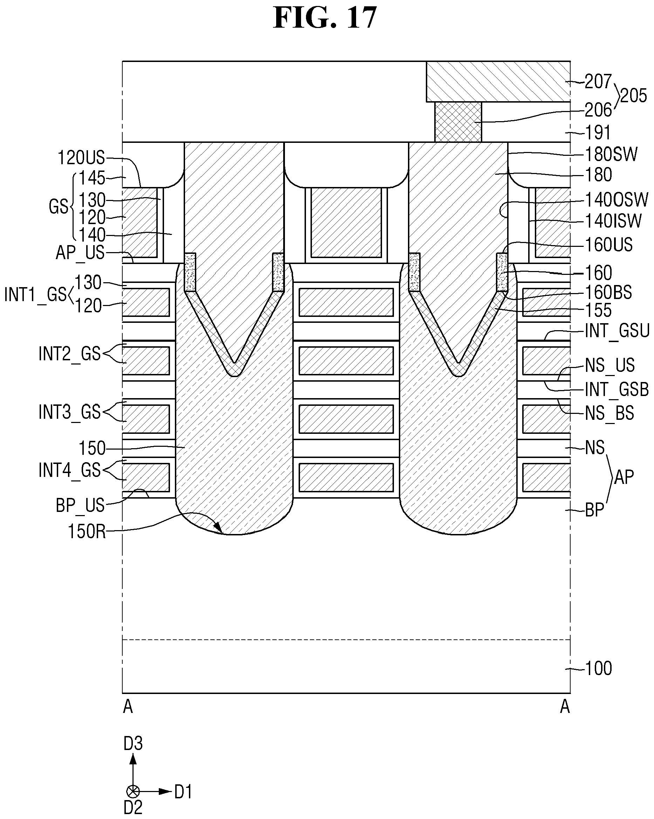

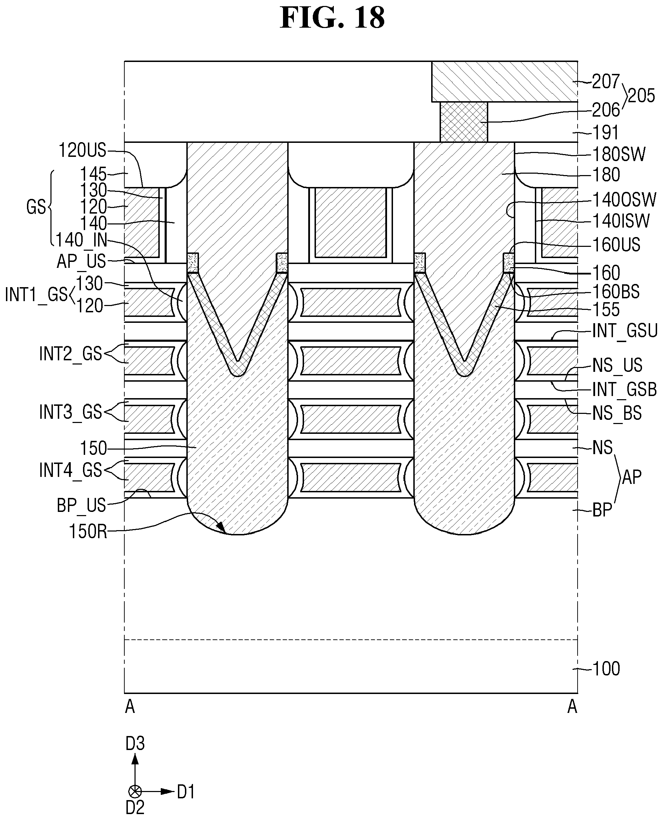

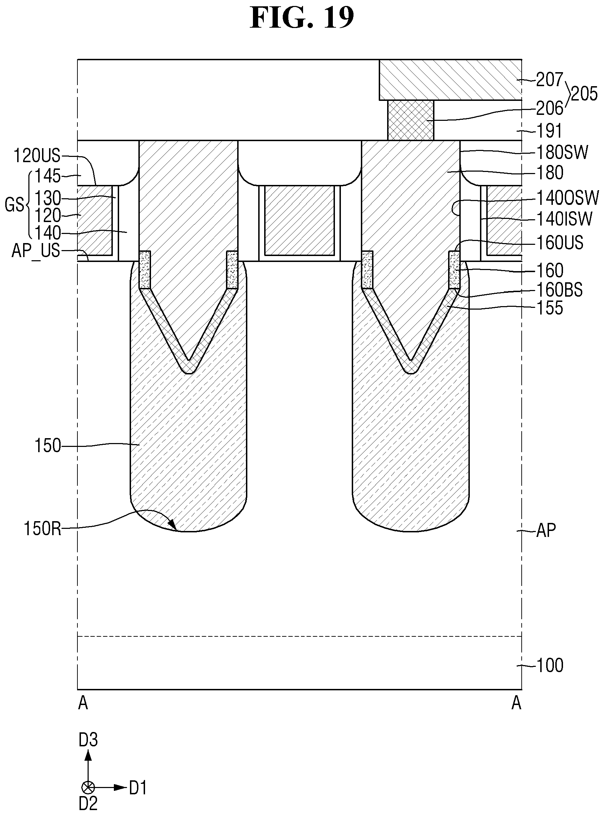

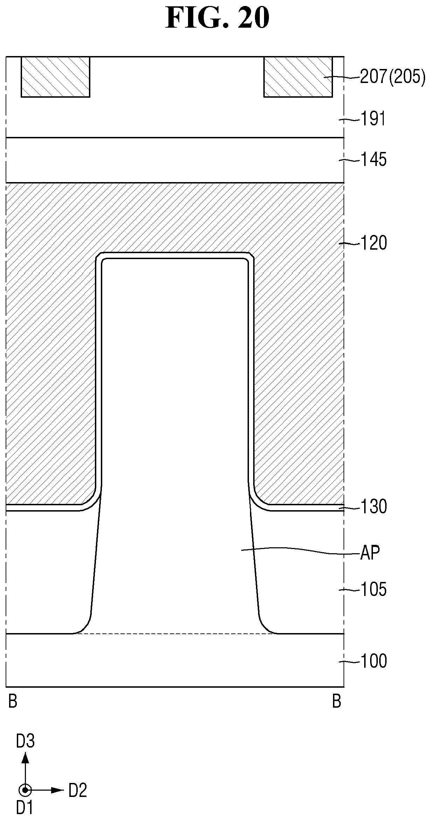

FIG. 17 is a diagram for explaining a semiconductor device according to some embodiments. FIG. 18 is a diagram for explaining a semiconductor device according to some embodiments. FIG. 19 and 20 are diagrams for explaining a semiconductor device according to some embodiments. For convenience of explanation, points that are different from those explained using FIGS. 1 to 5 will be mainly explained.

Referring to FIG. 17, in the semiconductor device according to some embodiments, a source/drain recess 150R does not include a plurality of width extension regions (150R_ER of FIG. 2).

The side walls of the source/drain recess 150R do not have a wavy shape. The width of the upper part of the side wall of the source/drain recess 150R in the first direction D1 may decrease with distance from the lower pattern BP.

Referring to FIG. 18, in the semiconductor device according to some embodiments, the gate structure GS may further include a plurality of inner spacers 140_IN.

The plurality of inner spacers 140_IN may be disposed between the sheet patterns NS adjacent to each other in the third direction D3, and between the lower pattern BP and the lowermost sheet pattern NS. The inner spacer 140_IN may be disposed between the upper surface BP_US of the lower pattern and the bottom surface NS_BS of the sheet pattern, and between the upper surface NS_US of the sheet pattern and the bottom surface NS_BS of the sheet pattern facing each other in the third direction D3.

The inner spacer 140_IN is disposed between the inner gate structures INT1_GS, INT2_GS, INT3_GS, and INT4_GS and the source/drain pattern 150. The number of inner spacers 140_IN aligned in the third direction D3 may be the same as the number of inner gate structures INT1_GS, INT2_GS, INT3_GS, and INT4_GS.

Each inner spacer 140_IN is in contact with a respective one of the inner gate structures INT1_GS, INT2_GS, INT3_GS, and INT4_GS. Therefore, the inner gate structures INT1_GS, INT2_GS, INT3_GS, and INT4_GS are not in contact with the source/drain pattern 150.

The inner spacer 140_IN may include, for example, at least one of silicon nitride (SiN), silicon oxynitride (SiON), silicon oxide (SiO₂), silicon oxycarbonitride (SiOCN), silicon boronitride (SiBN), silicon oxyboronitride (SiOBN), silicon oxycarbide (SiOC), and combinations thereof.

For example, the bottom surface 160BS of the silicide mask pattern may be higher than the upper surface INT_GSU of the first inner gate structure INT1_GS.

Referring to FIGS. 19 and 20, in the semiconductor device according to some embodiments, the active pattern AP does not include a sheet pattern (NS of FIG. 2).

The active pattern AP may be a fin-shaped pattern protruding above the upper surface of the field insulating film 105. The active pattern AP, which is a fin-shaped pattern, may be used as a channel region of the transistor including the gate electrode 120.

The gate structure GS does not include inner gate structures (INT1_GS, INT2_GS, INT3_GS, and INT4_GS of FIG. 2).

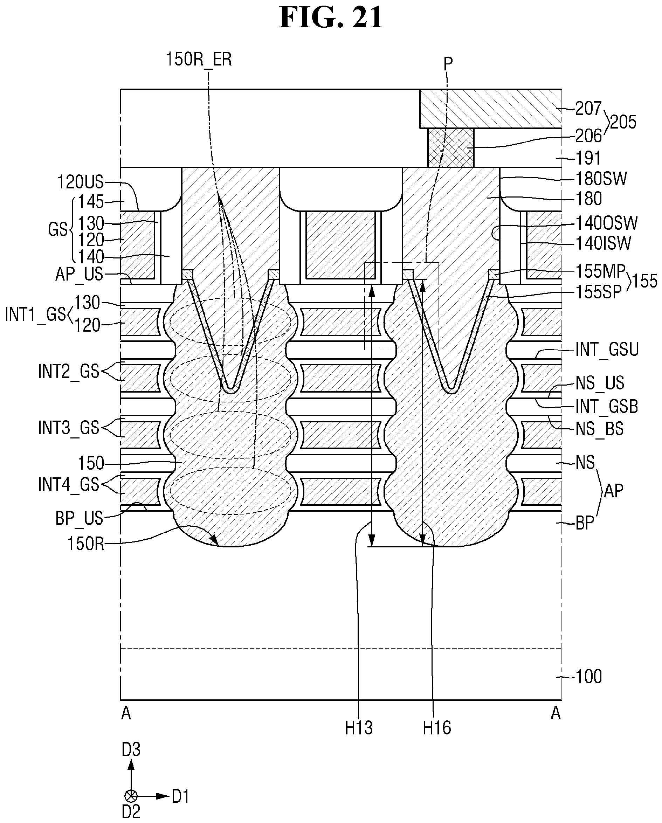

FIGS. 21 to 23 are diagrams for explaining a semiconductor device according to some embodiments. For convenience of explanation, points that are different from those explained using FIGS. 1 to 5 will be mainly explained.

Referring to FIGS. 21 to 23, in the semiconductor device according to some embodiments, the contact silicide film 155 may include a mask portion 155MP and a side surface portion 155SP.

The mask portion 155MP of the contact silicide film is disposed on the side surface portion 155SP of the contact silicide film. The mask portion 155MP of the contact silicide film is directly connected to the side surface portion 155SP of the contact silicide film. The entire side surface portion 155SP of the contact silicide film is disposed below the mask portion 155MP of the contact silicide film.

A silicide mask pattern (160 of FIG. 2) is not disposed between the source/drain contact 180 and the gate structure GS. The silicide mask pattern (160 of FIG. 4) is not disposed between the source/drain contact 180 and the first interlayer insulating film 190.

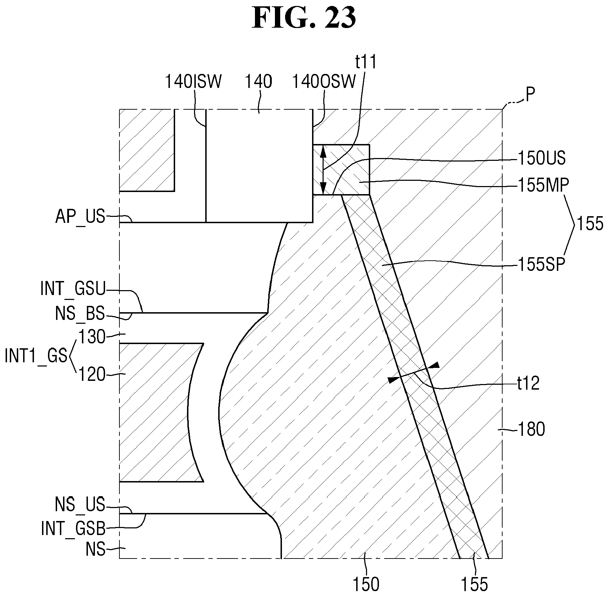

As shown, e.g., in FIGS. 21 and 23, a mask portion 155MP of the contact silicide film may be disposed on the upper surface 150US of the source/drain pattern. The upper surface 150US of the source/drain pattern may be higher than the upper surface AP_US of the active pattern. The height H13 from the lowermost part of the source/drain pattern 150 to the upper surface AP_US of the active pattern may be smaller than the height H16 from the lowermost part of the source/drain pattern 150 to the mask portion 155MP of the contact silicide film.

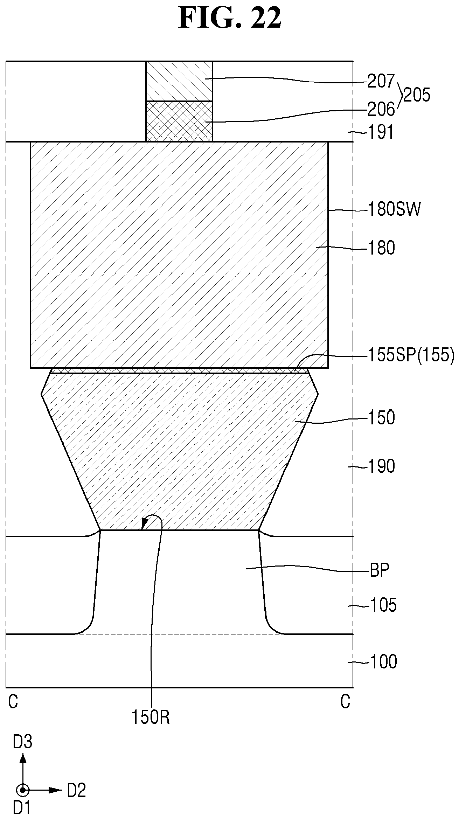

As shown, e.g., in FIG. 22, the contact silicide film 155 disposed between the source/drain pattern 150 and the source/drain contact 180 is the side surface portion 155SP of the contact silicide film. The mask portion 155MP of the contact silicide film is not disposed between the source/drain pattern 150 and the source/drain contact 180.

As an example, as shown in FIG. 23, a thickness t11 of the mask portion 155MP of the contact silicide film may be greater than a thickness t12 of the side surface portion 155SP of the contact silicide film. As another example, the thickness t11 of the mask portion 155MP of the contact silicide film may be the same as the thickness t12 of the side surface portion 155SP of the contact silicide film.

As an example, the metal silicide material included in the mask portion 155MP of the contact silicide film may be different from the metal silicide material included in the side surface portion 155SP of the contact silicide film. As another example, the metal silicide material included in the mask portion 155MP of the contact silicide film may be the same as the metal silicide material included in the side surface portion 155SP of the contact silicide film.

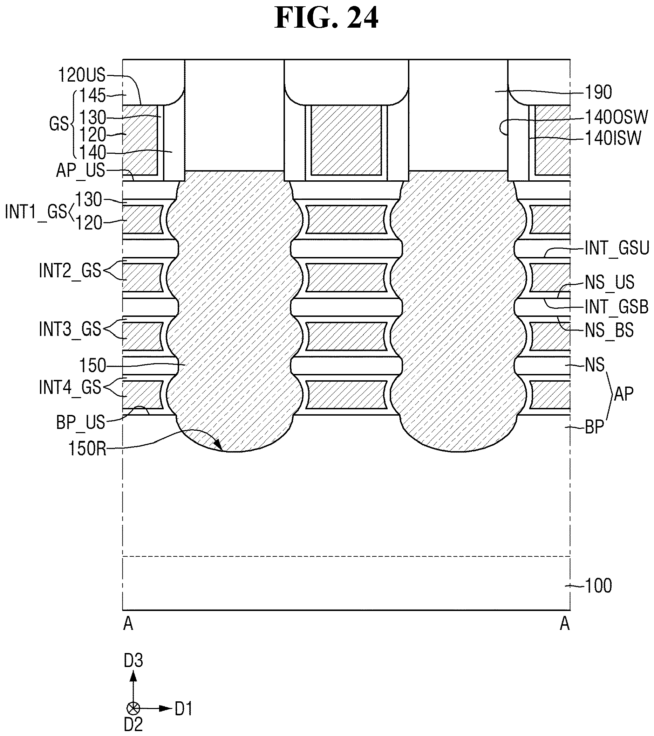

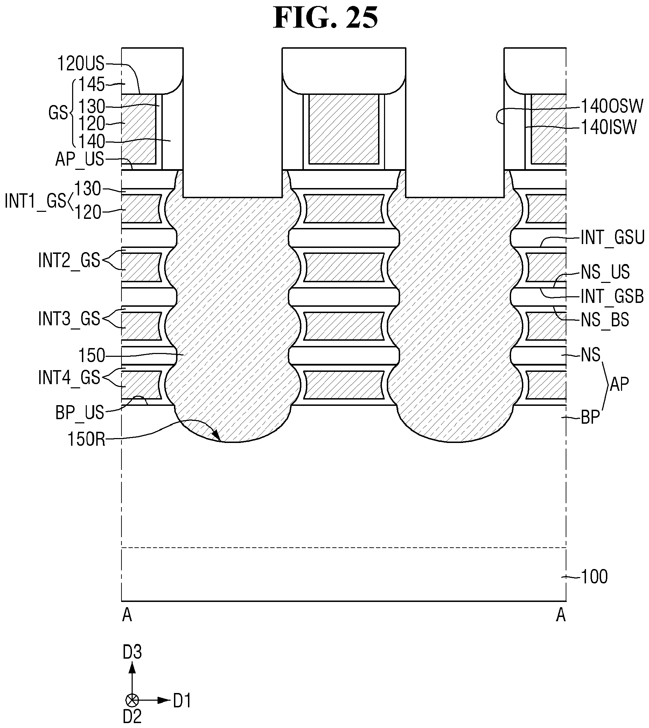

FIGS. 24 to 31 are intermediate step diagrams for describing a method for fabricating a semiconductor device according to some embodiments. For reference, FIGS. 24 to 31 may be the method for fabricating the semiconductor device described using FIGS. 1 to 5.

Referring to FIG. 24, the source/drain pattern 150 is formed on the lower pattern BP.

A gate spacer 140 may be formed on the lower pattern BP before the source/drain pattern 150 is formed.

The first interlayer insulating film 190 is formed on the source/drain pattern 150. Subsequently, the sheet pattern NS is formed on the lower pattern BP. Accordingly, the active pattern AP is formed on the substrate 100.

Next, the gate insulating film 130 and the gate electrode 120 that wrap the sheet pattern NS may be formed on the lower pattern BP. The gate capping pattern 145 may be formed on the gate electrode 120. Therefore, the gate structure GS may be formed on the active pattern AP. The upper surface of the first interlayer insulating film 190 may be disposed on the same plane as the upper surface of the gate capping pattern 145, but the disclosure is not limited thereto.

Referring to FIGS, 24 and 25, the first interlayer insulating film 190 may be removed to expose the source/drain patterns 150.

After the source/drain pattern 150 is exposed, a part of the source/drain patterns 150 may be removed to form a contact recess in the source/drain pattern 150.

While the contact recess is formed in the source/drain pattern 150, some of the first interlayer insulating film 190 and the source/drain patterns 150 may be removed even in the cross-sectional view such as FIG. 4. As an example, in the cross-sectional view such as FIG. 4, a height of a bottom surface of the recess formed by removal of the first interlayer insulating film 190 may be the same as a height of a bottom surface of the contact recess. As another example, the bottom surface of the recess formed by removal of the first interlayer insulating film 190 may be lower than the bottom surface of the contact recess.

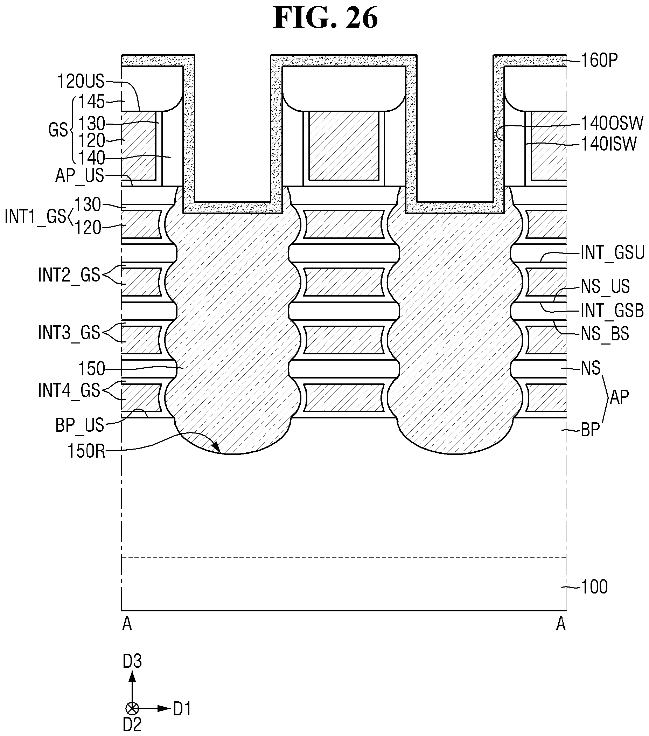

Referring to FIG. 26, a silicide mask film 160P may be formed along the side walls of the gate structure GS and the upper surface of the gate structure GS.

The silicide mask film 160P may be formed along the profile of the contact recess formed in the source/drain patterns 150.

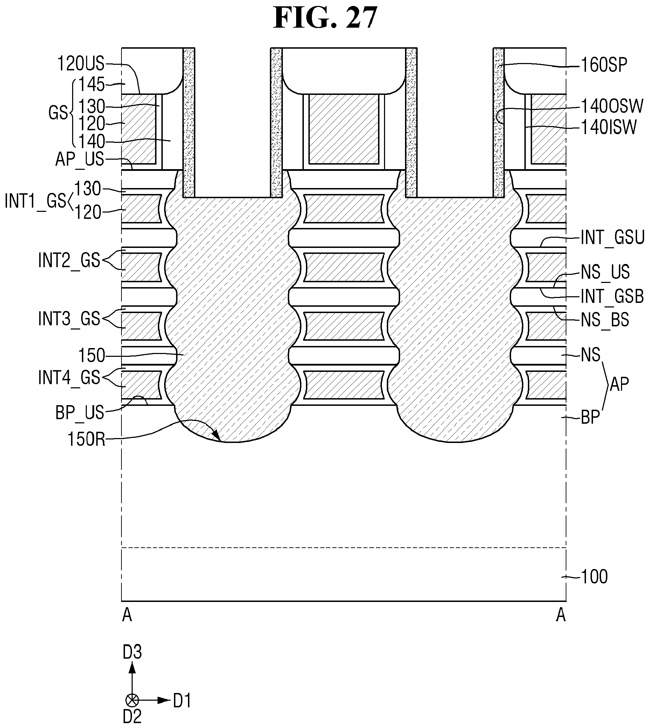

Referring to FIGS. 26 and 27, a pre-silicide mask pattern 160SP may be formed on the source/drain pattern 150.

The pre-silicide mask pattern 160SP may be formed by anisotropically etching the silicide mask film 160P.

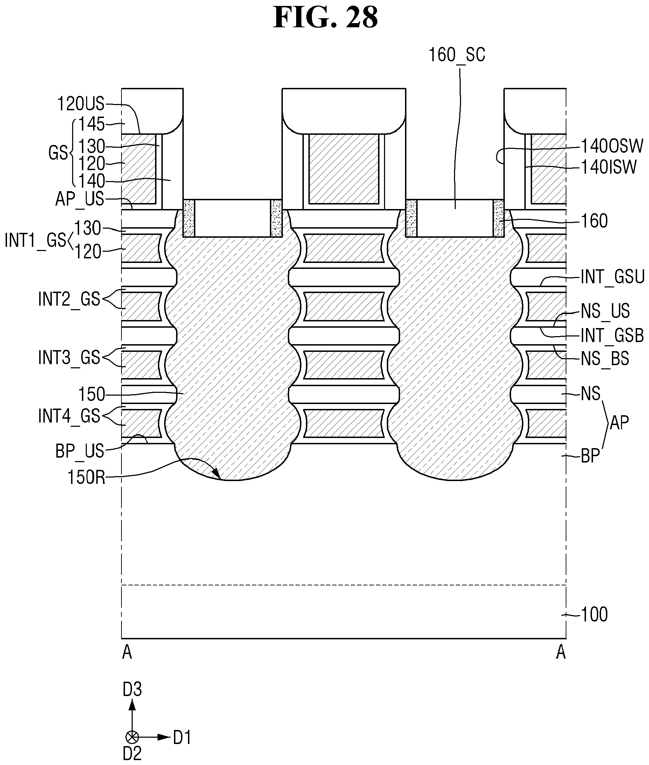

Referring to FIGS. 27 and 28, a mask sacrificial pattern 160_SC may be formed on the source/drain pattern 150.

The mask sacrificial pattern 160_SC may expose a part of the pre-silicide mask pattern 160SP. The mask sacrificial pattern 160_SC may include, for example, but is not limited to, an SOH (Spin On Hardmask).

Next, the silicide mask pattern 160 may be formed on the source/drain pattern 150 by removing the pre-silicide mask pattern 160SP protruding above the mask sacrificial pattern 160_SC.

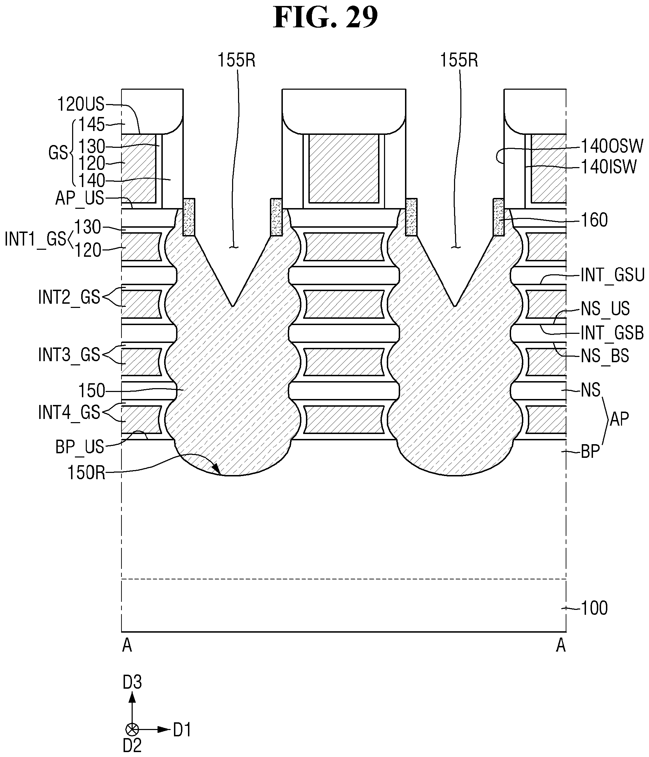

Referring to FIGS. 28 and 29, the mask sacrificial pattern 160_SC may be removed to expose the source/drain pattern 150.

A silicide recess 155R may then be formed in the source/drain patterns 150, using the silicide mask pattern 160 as a mask. A part of the source/drain pattern 150 exposed by the silicide mask pattern 160 may be removed to form the silicide recess 155R.

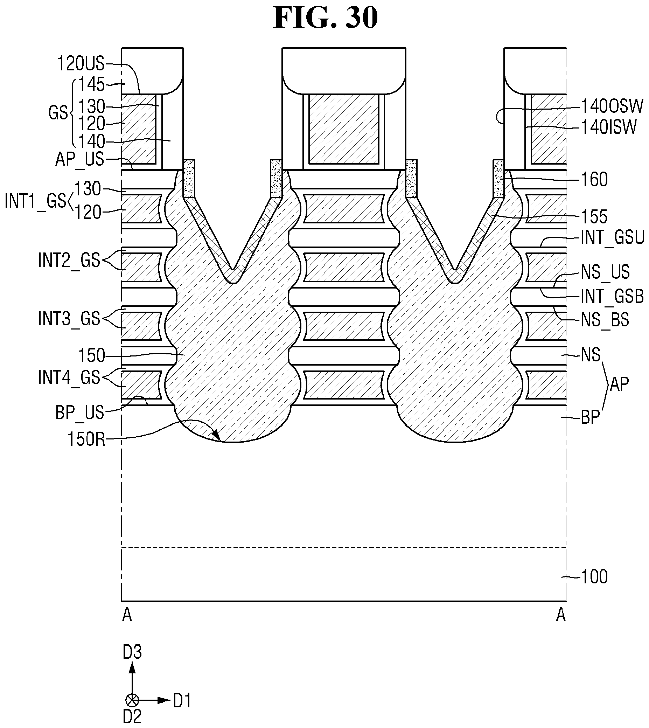

Referring to FIGS. 29 and 30, a contact silicide film 155 may be formed along the silicide recess 155R.

The contact silicide film 155 may be formed by converting the source/drain pattern 150 exposed by the silicide recess 155R through a silicide process.

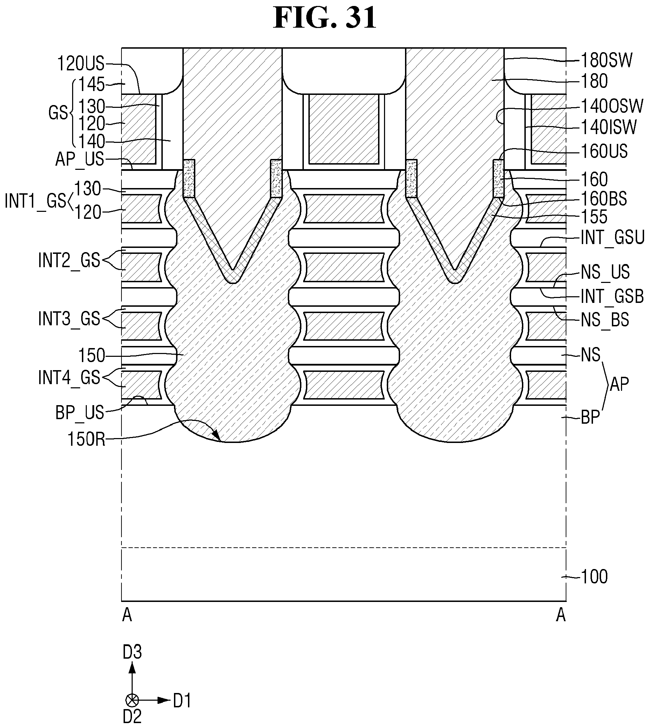

Referring to FIG. 31, the source/drain contact 180 is formed on the contact silicide film 155.

The source/drain contact 180 is in contact with the silicide mask pattern 160 and the gate structure GS.

Next, referring to FIG. 2, the wiring structure 205 connected to the source/drain contacts 180 may be formed on the source/drain contact 180.

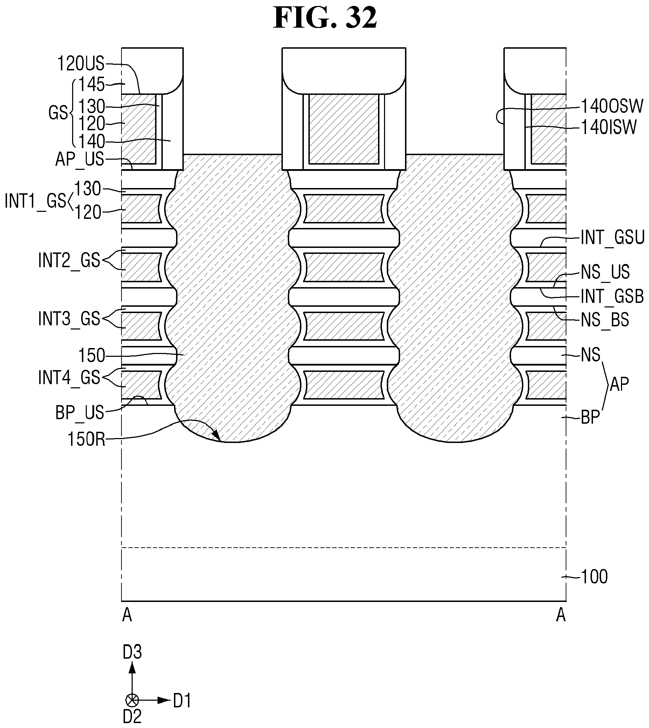

FIGS. 32 to 38 are intermediate step diagrams for explaining a method for fabricating a semiconductor device according to some embodiments. For reference, FIGS. 32 to 38 may be the method for fabricating the semiconductor device explained using FIGS. 21 to 23. FIG. 32 may be a process that is performed after FIG. 24.

Referring to FIG. 32, the first interlayer insulating film 190 may be removed to expose the source/drain pattern 150.

The upper surface of the source/drain pattern 150 may protrude above the upper surface AP_US of the active pattern.

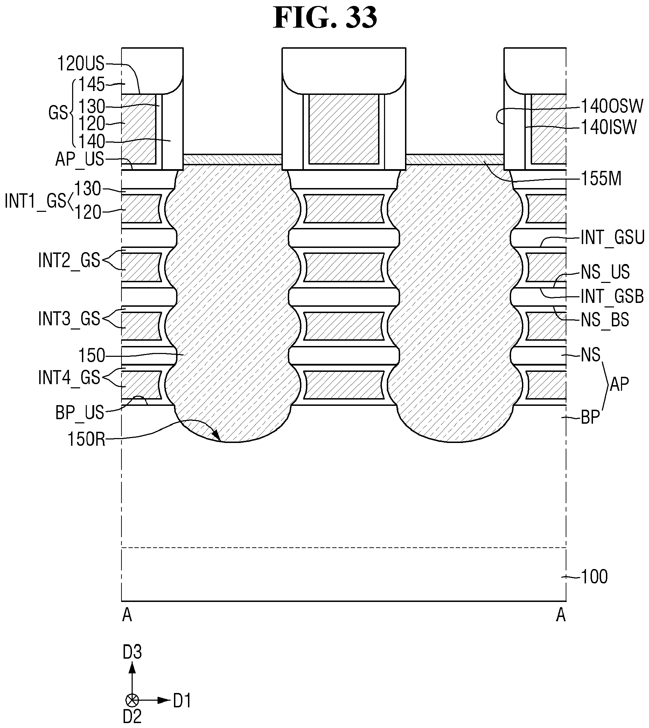

Referring to FIGS. 32 and 33, a silicide upper film 155M may be formed on the source/drain pattern 150.

A part of the source/drain pattern 150 may be converted through the silicide process to form the silicide upper film 155M.

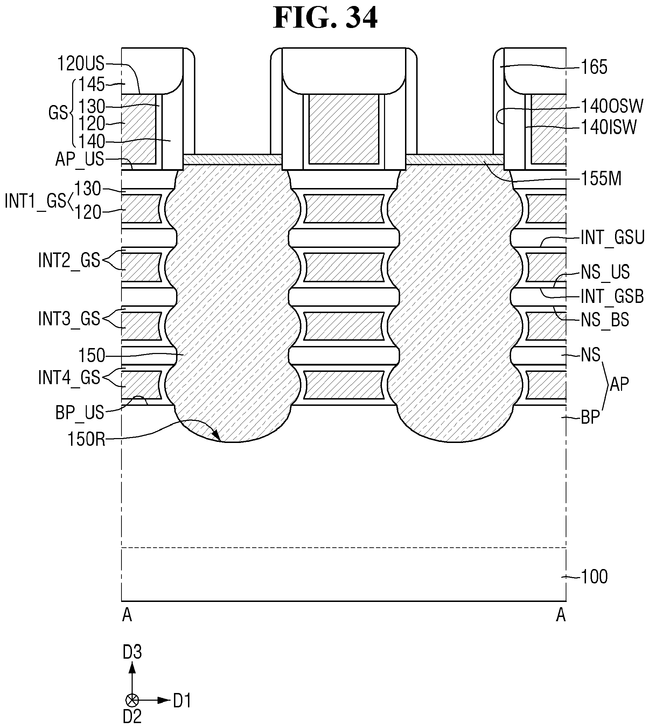

Referring to FIGS. 33 and 34, the silicide spacer 165 may be formed on the silicide upper film 155M.

The silicide spacer 165 may be formed along side walls of the gate structure GS. The silicide spacer 165 may expose a part of the silicide upper film 155M. The silicide spacer 165 may include, for example, an insulating material.

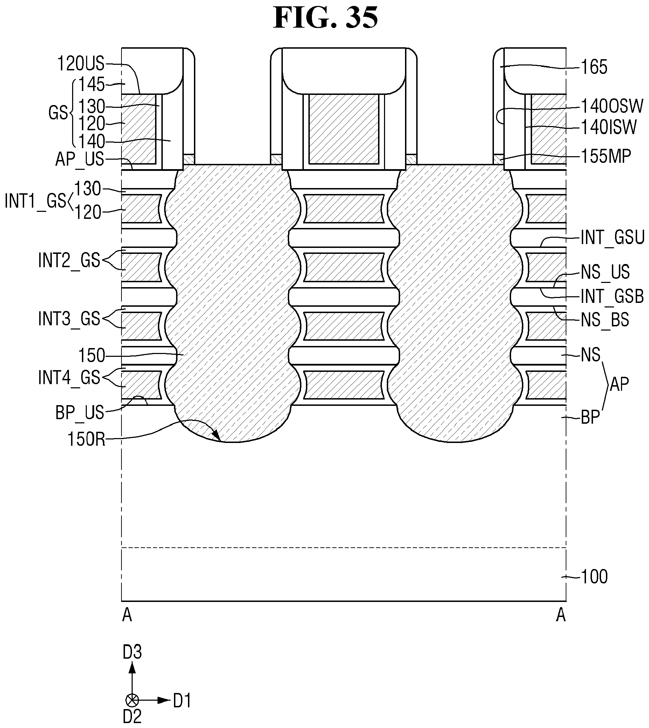

Referring to FIGS. 34 and 35, the mask portion 155MP of the contact silicide film may be formed on the source/drain pattern 150.

A part of the silicide upper film 155M may be removed using the silicide spacer 165 as a mask. Therefore, the mask portion 155MP of the contact silicide film may be formed.

Referring to 35 and 36, a part of the source/drain pattern 150 may be removed, using the silicide spacer 165 and the mask portion 155MP of the contact silicide film as masks.

A part of the source/drain pattern 150 is removed and the silicide recess 155R may be formed in the source/drain pattern 150.

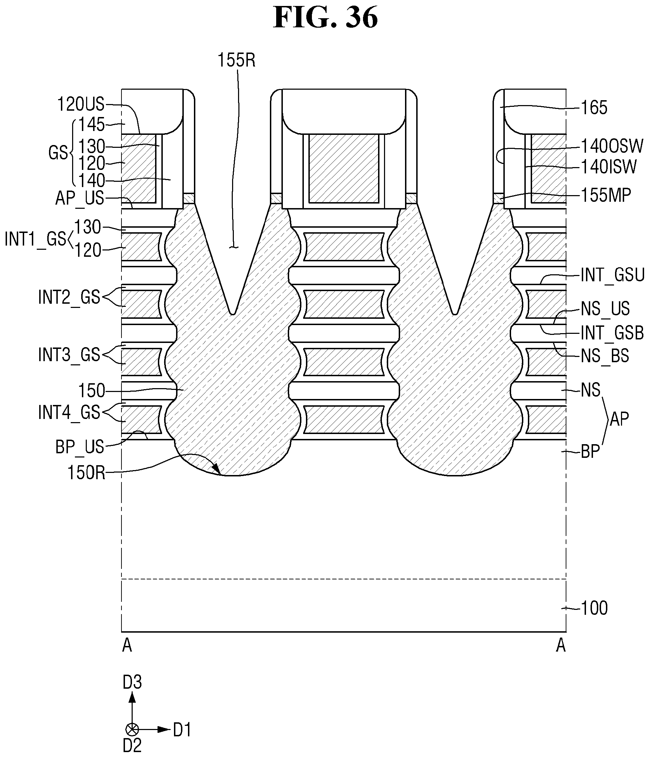

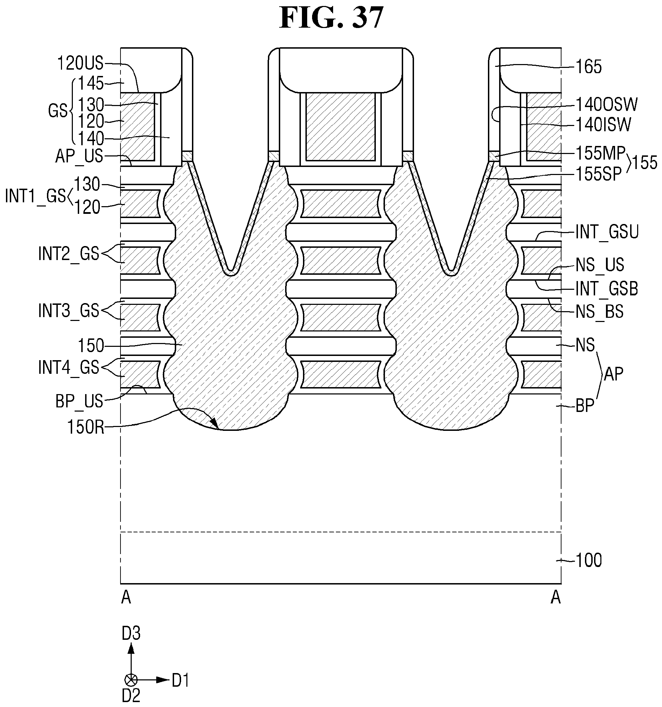

Referring to FIGS. 36 and 37, the side surface portion 155SP of the contact silicide film may be formed along the silicide recess 155R.

The side surface portion 155SP of the contact silicide film may be formed below the mask portion 155MP of the silicide film. Therefore, the contact silicide film 155 may be formed.

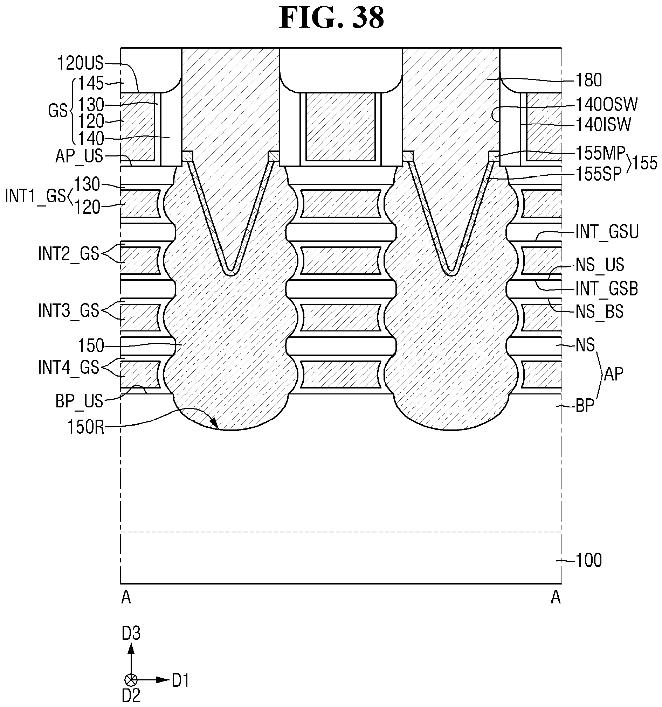

Referring to FIGS. 37 and 38, the silicide spacer 165 may be removed after forming the side surface portion 155SP of the contact silicide film.

After forming the silicide spacer 165, the source/drain contact 180 may be formed on the mask portion 155MP of the silicide film and the side surface portion 155SP of the contact silicide film.

In concluding the detailed description, those skilled in the art will appreciate that many variations and modifications may be made to embodiments without substantially departing from the principles of the disclosure. Therefore, embodiments of the disclosure are used in a generic and descriptive sense only and not for purposes of limitation.

## Claims

1. A semiconductor device comprising:
an active pattern extending in a first direction;
a plurality of gate structures on the active pattern and spaced apart in the first direction, each of the plurality of gate structures comprising a gate electrode extending in a second direction, and a gate spacer on side walls of the gate electrode;
a source/drain pattern between adjacent ones of the plurality of gate structures;
a silicide mask pattern on the source/drain pattern, the silicide mask pattern comprising an upper surface and a bottom surface opposite to each other in a third direction, the upper surface of the silicide mask pattern being lower than an upper surface of the gate electrode;
a source/drain contact on the source/drain pattern and connected to the source/drain pattern; and
a contact silicide film between the source/drain contact and the source/drain pattern, the contact silicide film contacting the bottom surface of the silicide mask pattern,
wherein a height from a lowermost part of the source/drain pattern to a lowermost part of the source/drain contact is smaller than a height from the lowermost part of the source/drain pattern to the bottom surface of the silicide mask pattern.

2. The semiconductor device of claim 1,
wherein the source/drain contact covers the upper surface of the silicide mask pattern.

3. The semiconductor device of claim 1 or 2,
wherein the height from the lowermost part of the source/drain pattern to the bottom surface of the silicide mask pattern is smaller than the height from the lowermost part of the source/drain pattern to an upper surface of the active pattern.

4. The semiconductor device of claim 1, 2 or 3,
wherein the height from the lowermost part of the source/drain pattern to the upper surface of the silicide mask pattern is greater than the height from the lowermost part of the source/drain pattern to an upper surface of the active pattern.

5. The semiconductor device of any preceding claim,
wherein a respective side wall of the source/drain contact is in contact with a side wall of a respective gate structure of the plurality of gate structures.

6. The semiconductor device of any preceding claim,
wherein the active pattern comprises a lower pattern extending in the first direction and a plurality of sheet patterns spaced apart from the lower pattern in the third direction, and
wherein each of the plurality of gate structures comprises an inner gate structure between the lower pattern and the sheet pattern, and between adjacent sheet patterns of the plurality of sheet patterns.

7. The semiconductor device of claim 6,
wherein each of the plurality of gate structures comprises a gate insulating film, and
wherein each gate insulating film included in a respective inner gate structure contacts the source/drain pattern.

8. The semiconductor device of claim 6,
wherein each of the plurality of gate structures comprises a plurality of inner spacers between the lower pattern and a sheet pattern of the plurality of sheet patterns, and between adjacent ones of the plurality of sheet patterns.

9. A semiconductor device comprising:
an active pattern comprising a lower pattern extending in a first direction, and a plurality of sheet patterns spaced apart from the lower pattern in a third direction, the plurality of sheet patterns comprising an uppermost sheet pattern;
a plurality of gate structures on the lower pattern spaced apart in the first direction, each of the plurality of gate structures comprising a gate electrode extending in a second direction;
a source/drain pattern on the lower pattern and connected to the sheet patterns;
a silicide mask pattern on the source/drain pattern, the silicide mask pattern comprising an upper surface and a bottom surface opposite to each other in the third direction, the upper surface of the silicide mask pattern being higher than an upper surface of the uppermost sheet pattern, and lower than an upper surface of the gate electrode;
a source/drain contact on the source/drain pattern and connected to the source/drain pattern; and
a contact silicide film between the source/drain contact and the source/drain pattern, the contact silicide film contacting the bottom surface of the silicide mask pattern.

10. The semiconductor device of claim 9,
wherein a height from a lowermost part of the source/drain pattern to the bottom surface of the silicide mask pattern is smaller than a height from the lowermost part of the source/drain pattern to the upper surface of the uppermost sheet pattern.

11. The semiconductor device of claim 9 or 10,
wherein each of the plurality of gate structures comprises a gate spacer on a side wall of the gate electrode, and
wherein a side wall of the source/drain contact is in contact with an outer side wall of the gate spacer.

12. The semiconductor device of claim 9, 10 or 11,
wherein the source/drain contact covers the upper surface of the silicide mask pattern.

13. A semiconductor device comprising:
an active pattern comprising:
a lower pattern extending in a first direction, and
a plurality of sheet patterns spaced apart from the lower pattern in a third direction, the plurality of sheet patterns comprising an uppermost sheet pattern;
a plurality of gate structures on the lower pattern spaced apart in the first direction, each of the plurality of gate structures comprising a gate electrode extending in a second direction and a gate spacer on a side wall of the gate electrode;
a source/drain pattern on the lower pattern and connected to the sheet patterns;
a silicide mask pattern on the source/drain pattern, the silicide mask pattern comprising an upper surface and a bottom surface opposite to each other in the third direction;
a source/drain contact on the source/drain pattern, the source/drain contact being in contact with the upper surface of the silicide mask pattern, a side wall of the source/drain contact being in contact with an outer side wall of the gate spacer; and
a contact silicide film between the source/drain contact and the source/drain pattern, the contact silicide film being in contact with the bottom surface of the silicide mask pattern,
wherein each of the plurality of gate structures comprises a plurality of inner gate structures disposed between the lower pattern and the plurality of sheet patterns, and between adjacent ones of the plurality of sheet patterns,
wherein each of the plurality of inner gate structures comprises an uppermost inner gate structure in contact with a bottom surface of the uppermost sheet pattern, and
wherein the bottom surface of the silicide mask pattern is lower than the upper surface of the uppermost inner gate structure, and is higher than the bottom surface of the uppermost inner gate structure.

14. The semiconductor device of claim 13,
wherein the upper surface of the silicide mask pattern is higher than the upper surface of the uppermost sheet pattern.

15. The semiconductor device of claim 13 or 14,
wherein each of the plurality of gate structures comprises a gate insulating film, and
wherein the gate insulating film included in each of the plurality of inner gate structures is in contact with the source/drain pattern.
